# EUROPEAN PATENT SPECIFICATION

(11) **EP 0 589 309 B1**
(45) Date of publication and mention of the grant of the patent: **21.01.1998**
(21) Application number: 93114594.0
(22) Date of filing: 10.09.1993
(51) Int. Cl.: G03F 7/004, G03F 7/039, G03F 7/023, G03F 7/016

(54) **Use of a positive-working presensitized plate for making lithographic printing plate**
Verwendung einer positiv arbeitenden vorsensibilisierten Druckplatte zur Herstellung einer lithographischen Druckplatte
Utilisation d'une plaque présensibilisée positive pour la production d'une plaque d'impression lithographique

(30) Priority: 14.09.1992 JP 245049/92
(43) Date of publication of application: 30.03.1994
(73) Proprietor: Fuji Photo Film Co., Ltd., Kanagawa-ken (JP)
(72) Inventor: Kawauchi, Ikuo, c/o Fuji Photo Film Co., Ltd., Haibara-gun, Shizuoka-ken (JP); Nagashima, Akira, c/o Fuji Photo Film Co., Ltd., Haibara-gun, Shizuoka-ken (JP); Mizutani, Kazuyoshi, c/o Fuji Photo Film Co., Ltd., Haibara-gun, Shizuoka-ken (JP)
(74) Representative: Grünecker, Kinkeldey, Stockmair & Schwanhäusser Anwaltssozietät

(56) References cited:
- EP-A- 0 424 124
- EP-A- 0 460 416
- EP-A- 0 477 691
- EP-A- 0 541 112
- A. KNOP, L. PILATO 'Phenolic Resins' 1985 , SPRINGER-VERLAG , BERLIN, HEIDELBERG, DE
- ANG. MAKROMOL. CHEMIE vol. 131, no. 2080, 1985, BASEL, HEIDELBERG, NEW YORK pages 25 - 44 R. STEFFAN 'Computer-Simulation der Polykondensation von Phenol mit Formaldehyd'

## Description

The present invention is directed to the use of a positive-working presensitized plate for making a lithographic printing plate.

Methods for preparing a lithographic printing plate by exposing, to light, a positive-working presensitized plate for use in making a lithographic printing plate (hereinafter referred to as "(positive-working) PS plate"), developing the exposed positive-working PS plate and then subjecting the developed PS plate to a heat-treatment (hereinafter referred to as "burning treatment") are disclosed in, for instance, U.K. Patent Nos. 1,151,199 and 1,154,749. The burning treatment is generally carried out by heating the developed PS plate at a temperature ranging from 200 to 320°C for 1 to 60 minutes. The image areas of the PS plate are hardened and the printing durability thereof is markedly improved through the burning treatment. In the non-image areas thereof, in particular the shadowed areas, however, ink-receptive organic substances flowing out of half tone dot images are firmly adhered to the non-image areas and this leads to background contamination during printing operations. This phenomenon will hereinafter be referred to as "ink spreading due to burning treatment". It has generally been known that the ink spreading due to burning treatment becomes conspicuous as the temperature for the buring treatment increases.

To solve this problem, Japanese Patent Publication for Opposition Purpose (hereinafter referred to as "J.P. KOKOKU") No. Hei 1-49932 discloses additives which permit the improvement of the printing durability of the resulting lithographic printing plate obtained after the burning treatment. This patent discloses that the use of these additives permits the achievement of printing durability, through burning treatment at a low temperature (for instance, on the order of 180 °C), comparable to that achieved by the usual burning treatment which is carried out at 200 to 320°C. However, the ink spreading due to burning treatment is in fact observed even when the burning treatment is carried out at 180 °C, the ink spreading due to burning treatment becomes conspicuous when the burning treatment is performed at a temperature currently used and, therefore, the use of such an additive is not a substantial solution for the foregoing problem. Moreover, the patent requires the use of a large amount of a hydrophilic additive and this results in the substantial reduction of other printing properties such as the development latitude and/or ink receptivity of the resulting lithographic printing plate.

European Patent No. 477691 discloses a positive-type photoresist composition comprising an alkali-soluble phenol novolak, a 1,2-quinone diazide compound and a low molecular weight compound having 12 to 50 carbon atoms per molecule and 2 to 8 phenolic hydroxyl groups per molecule. The composition is suitable for the production of semiconductors such as integrated circuits.

European Patent No. 460416 discloses a positive resist composition comprising a radiation-sensitive compound and an alkali-soluble resin which is obtainable by a condensation reaction of an aldehyde and a specific hydroxyl group-containing compound. The composition is suitable for the production of semiconductors such as integrated circuits.

European Patent No. 424124 discloses a positive-acting photoresist composition comprising an alkali-soluble binder comprising a plurality of phenol groups, a specific iodonium salt and a specific acid-cleavable compound.

The object of the present invention is to provide a novel use of a positive-working presensitized plate.

This object is solved by the use of a positive-working presensitized plate for making a lithographic printing plate, said positive-working presensitized plate comprising a substrate provided thereon with a light-sensitive layer. wherein the light-sensitive layer is formed from a positive-working light-sensitive composition comprising a phenol derivative, a water-insoluble and alkaline water-soluble resin and an o-quinonediazide or a diazonium salt or a mixture of a compound capable of forming an acid through exposure to light with a compound having at least one C-O-C group capable of being decomposed by the action of the acid, said phenol derivative and said water-insoluble and alkaline water-soluble resin being different from each other, said phenol derivative being at least one member selected from the group consisting of those represented by the following general formulas (II) to (IX): 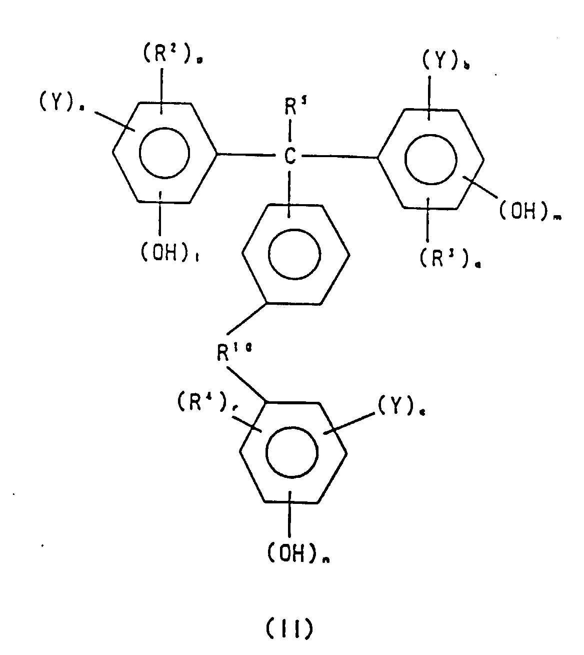 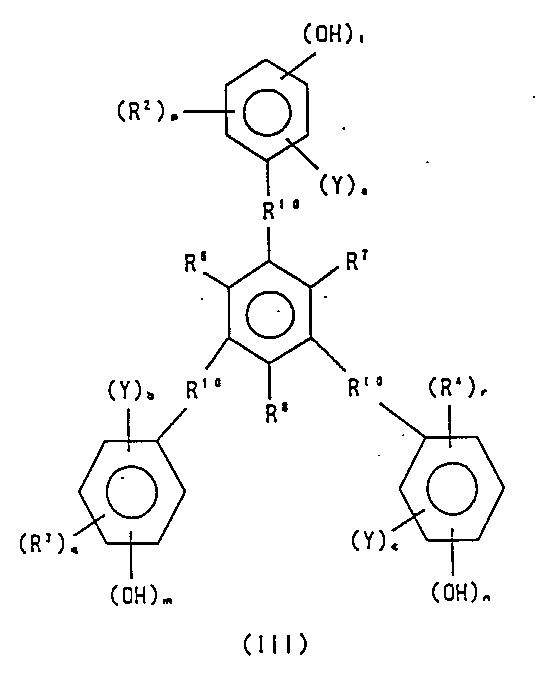 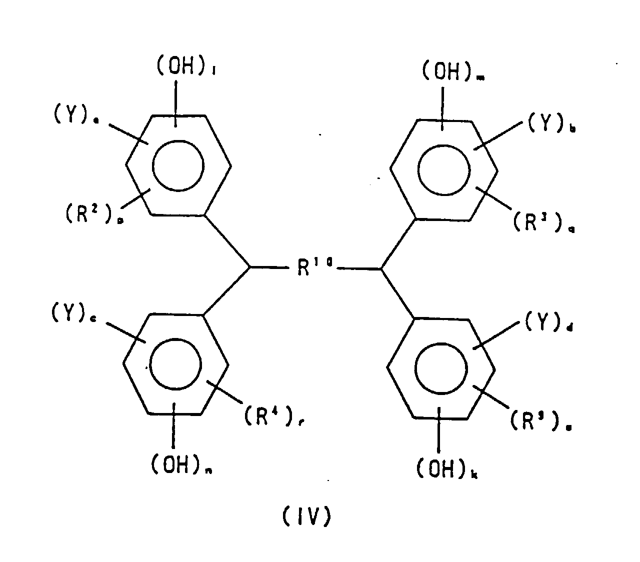 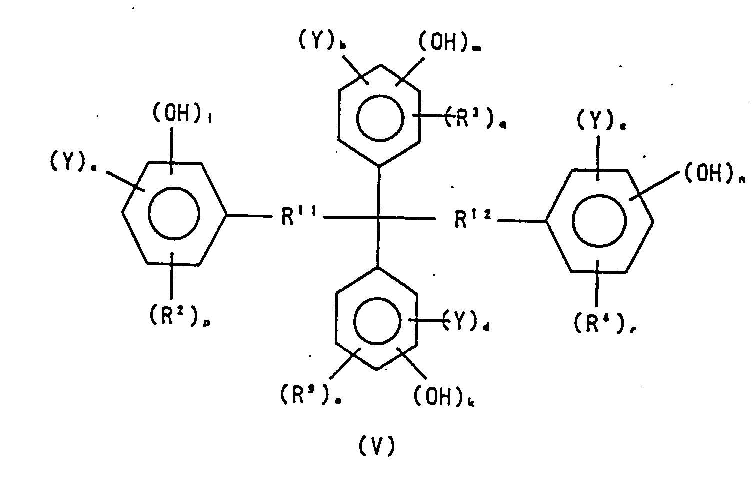 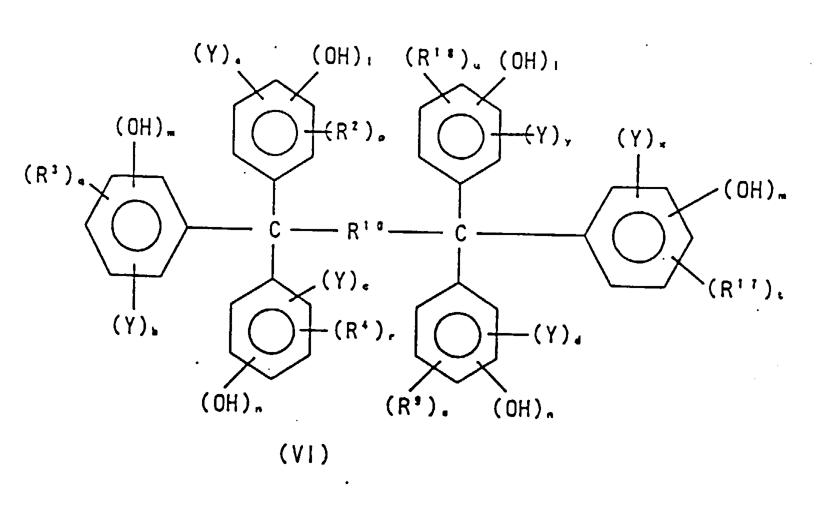 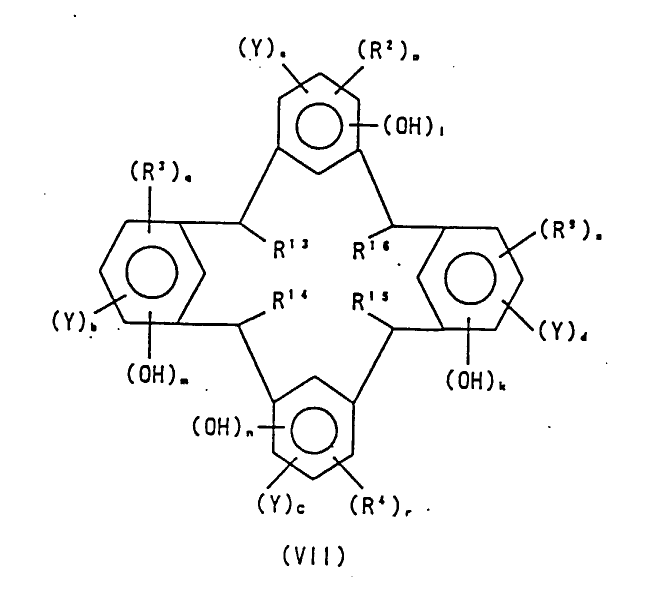 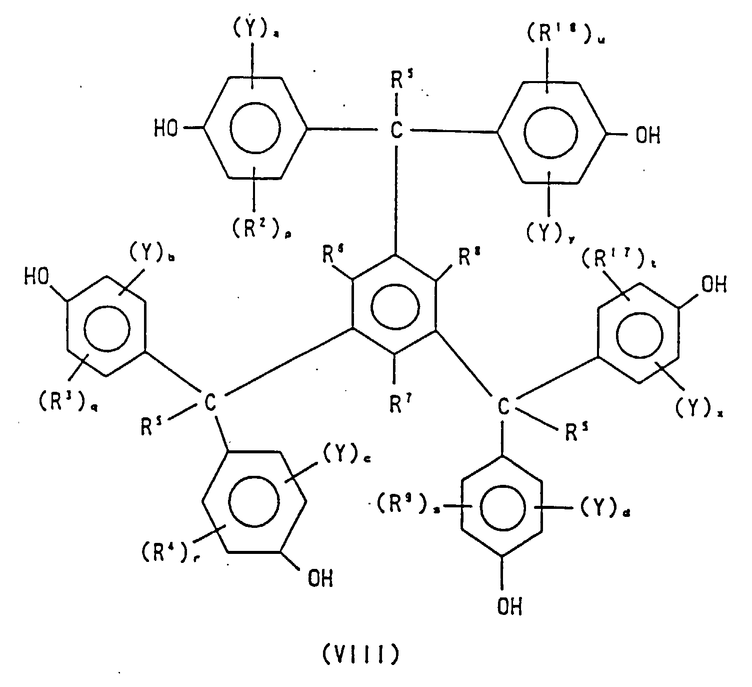 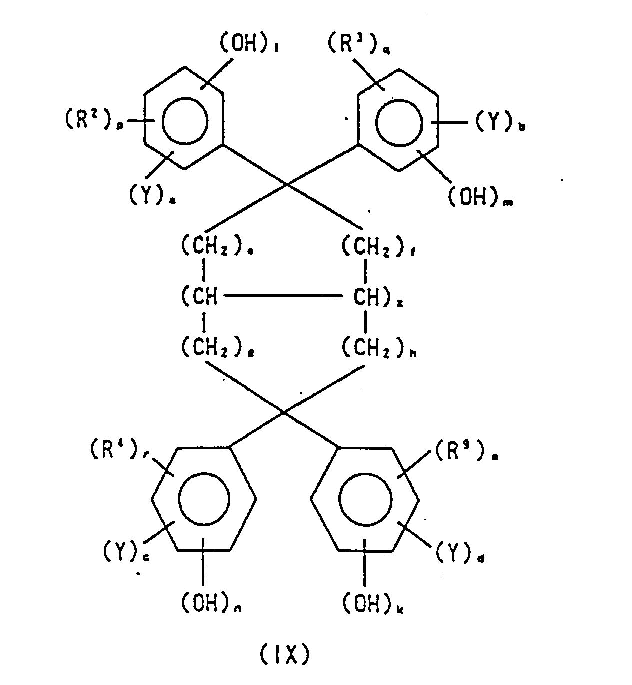 wherein R² to R⁴, R⁹, R¹⁷ and R¹⁸ each represents a hydrogen or halogen atom or an alkyl or alkoxy group; R⁵ and R¹³ to R¹⁶ each represents a hydrogen atom or an alkyl group; R⁶ to R⁸ each represents a hydrogen or halogen atom or an alkyl group; R¹⁰ to R¹² each represents a single bond, a substituted or unsubstituted alkylene, alkenylene, phenylene, naphthylene, carbonyl, ether or thioether group, or an amido bond, or a group formed from at least two of these groups; Y represents a group represented by the following general formula (I):

-CH₂OR¹ (I)

wherein R¹ represents a hydrogen atom, an alkyl or an acyl group; a, b, c, d, x and y each represents an integer ranging from 0 to 3, provided that the sum of them, a+b+c+d+x+y, is an integer ranging from 2 to 16; k, l, and n each represents an integer ranging from 0 to 3, provided that all of them are not simultaneously 0; e, f, g, h, p, q, r, s, t and u each represents an integer ranging from 0 to 3; and z is 0 or 1.

Such a positive-working PS plate does not suffer from a problem of contamination (ink spreading due to burning treatment) even if it is subjected to a burning treatment carried out at a high temperature.

Moreover, such a positive-working PS plate has a wide development latitude, which can provide a lithographic printing plate having good ink receptivity.

The present invention will hereinafter be explained in more detail.

### (I) Phenol Derivatives

The intended effect of the present invention can be ensured through the use of the specific phenol derivative defined above. In the foregoing Formula (I), the alkyl group denoted by R¹ may preferably be an alkyl group having 1 to 4 carbon atoms such as a methyl, ethyl, n-propyl, isopropyl, n-butyl, isobutyl, sec-butyl or t-butyl group and the acyl group denoted by R¹ may preferably be a formyl, acetyl, butyryl, benzoyl, cinnamoyl or valeryl group.

The phenol derivatives used in the invention may be prepared by. for instance, reacting suitable phenol compounds such as those disclosed in Japanese Un-examined Patent Publication (hereunder referred to as "J.P. KOKAI") Nos. Hei 1-289946, Hei 3-179353, Hei 3-200252, Hei 3-128959 and Hei 3-200254 and Japanese Patent Application Serial (hereinafter referred to as "J.P.A.") Nos. Hei 3-320438 and Hei 4-25157 with formaldehyde at a temperature ranging from about 0 to 80 °C, preferably 10 to 60 °C for 1 to 30 hours in a strongly alkaline medium. The number of the groups represented by Formula (I) can be controlled by appropriately adjusting the reaction temperature and time, but the number thereof suitably ranges from 2 to 16 and preferably 4 to 14.

The phenol derivatives used in the invention are those represented by the general formulas (II) to (IX) detailed below. Preferred are those represented by the general formulas (II) to (IX) wherein all of a. b. c, d, x and y are 0. These phenol derivatives may be used alone or in combination and the amount thereof used in the light-sensitive composition ranges from 0.2 to 60% by weight, preferably 0.5 to 20% by weight on the basis of the total weight of the composition.

In addition, it is preferred that the light-sensitive composition is substantially free of a compound having 1 to 3 benzene nuclei, a phenolic hydroxyl group and a group represented by Formula (I) since the compound does not have an effect of eliminating the ink spreading due to burning treatment and leads to reduction of ink receptivity and development latitude of the resulting PS plate. More specifically, the amount of such a compound is preferably not more than 5% by weight, more preferably not more than 3% by weight and most preferably 0% by weight on the basis of the weight of the light-sensitive composition.

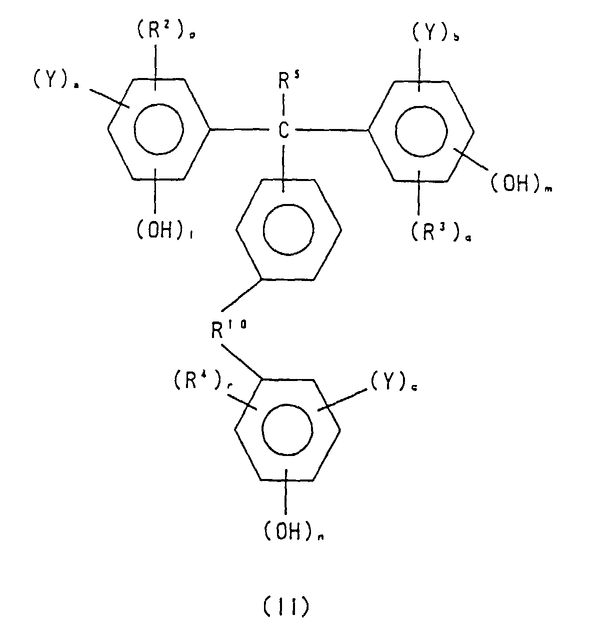

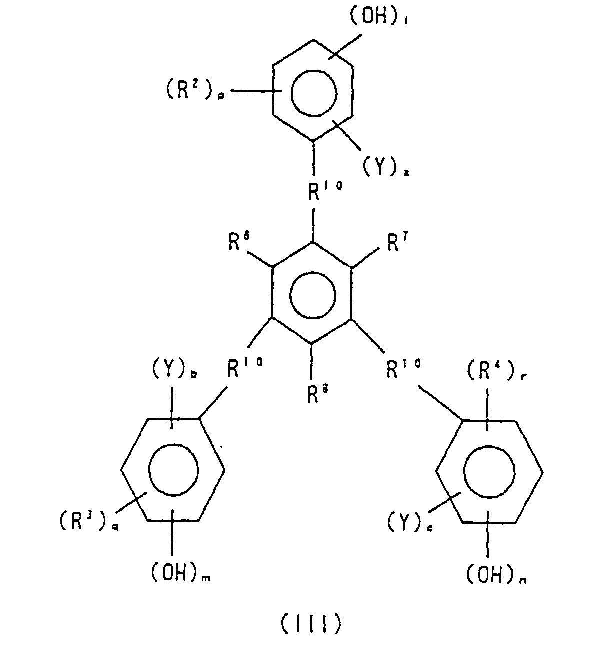

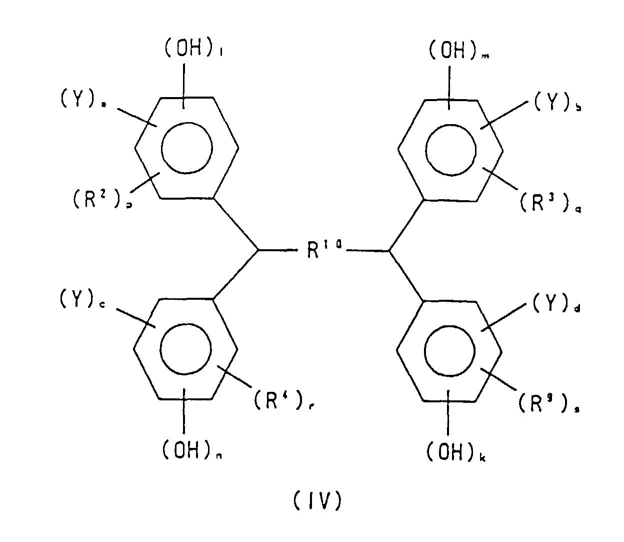

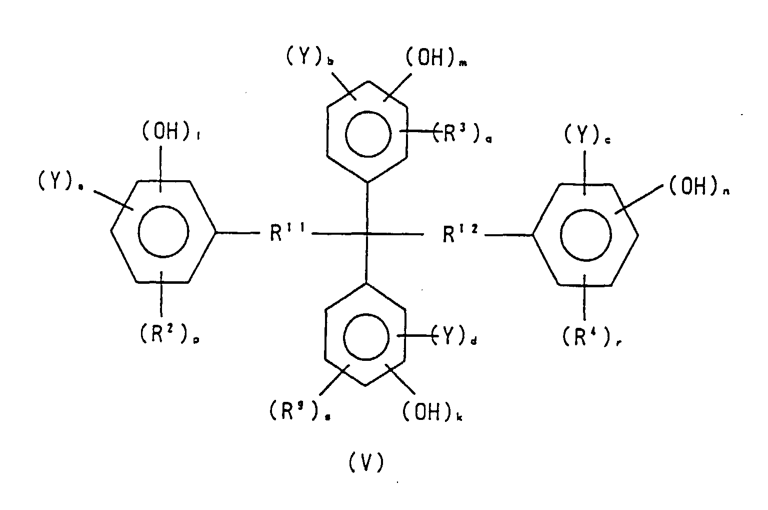

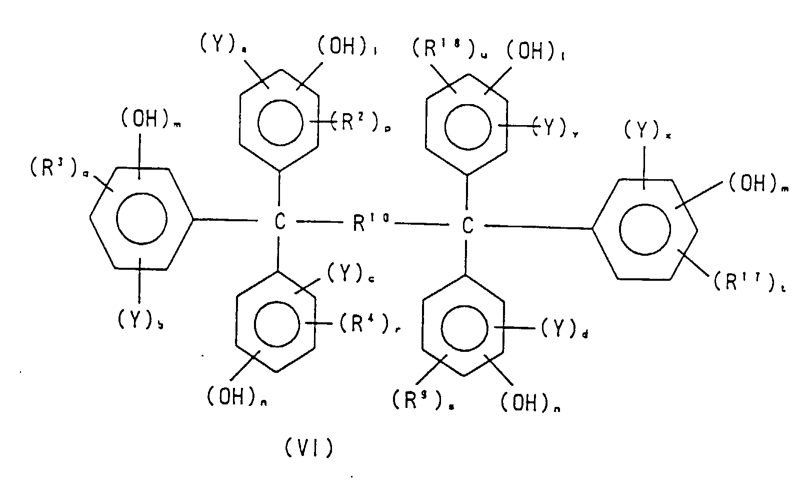

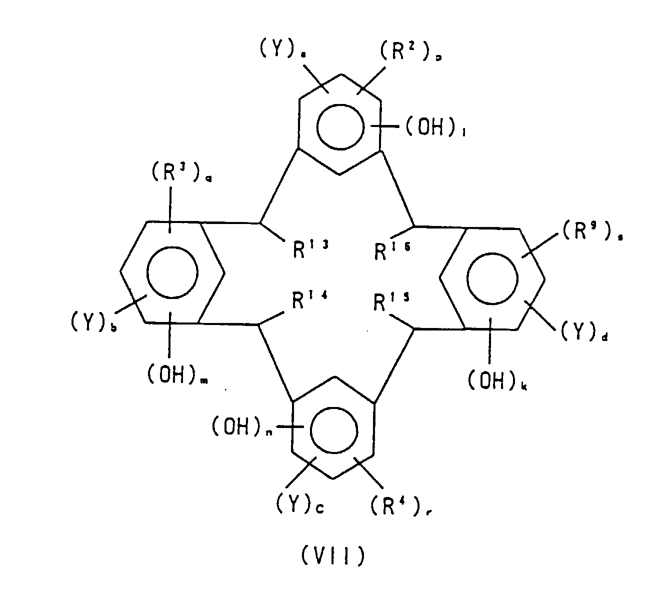

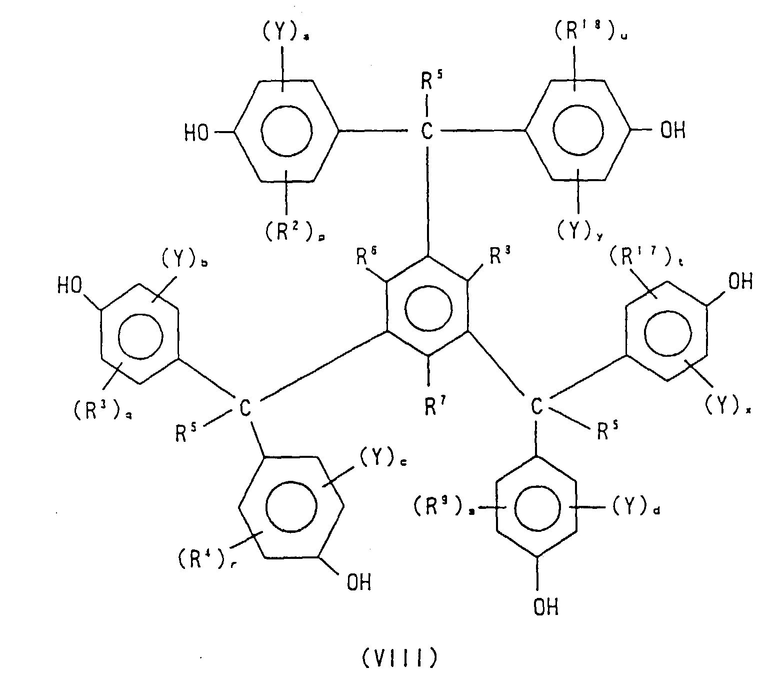

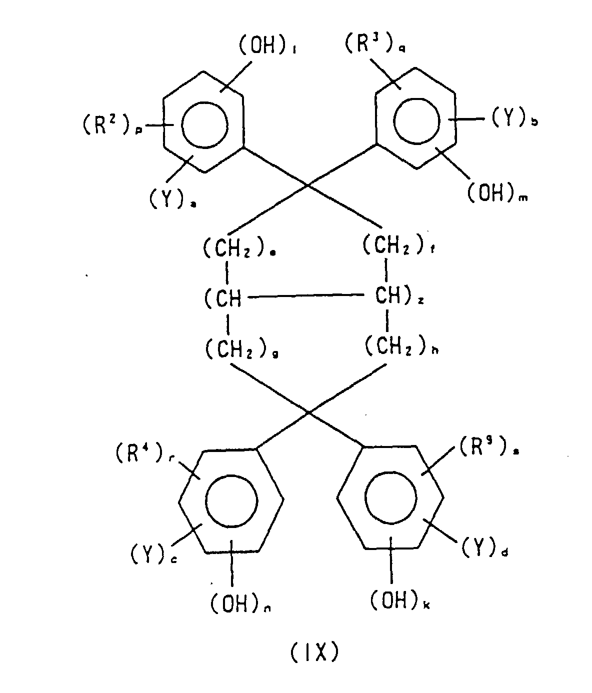

In these Formulas (II) to (IX), R² to R⁴, R⁹, R¹⁷ and R¹⁸ each represents a hydrogen or halogen atom or an alkyl or alkoxy group; R⁵ and R¹³ to R¹⁶ each represents a hydrogen atom or an alkyl group; R⁶ to R⁸ each represents a hydrogen or halogen atom or an alkyl group; R¹⁰ to R¹² each represents a single bond, a substituted or unsubstituted alkylene, alkenylene, phenylene, naphthylene, carbonyl, ether or thioether group. or an amido bond, or a group formed from at least two of these groups; Y represents a group represented by Formula (I); a, b, c, d, x and y each represents an integer ranging from 0 to 3, provided that the sum of them, a+b+c+d+x+y, is an integer ranging from 2 to 16; k, l, m and n each represents an integer ranging from 0 to 3, provided that all of them are not simultaneously 0; e, f, g, h, p, q, r, s, t and u each represents an integer ranging from 0 to 3; and z is 0 or 1.

More specific examples of the compounds represented by Formulas (II) to (IX) are those having structures represented by the following general formulas (X) to (XVII): 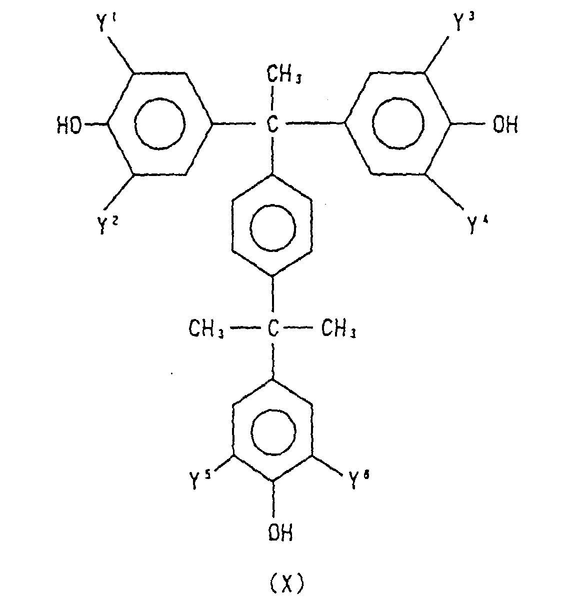 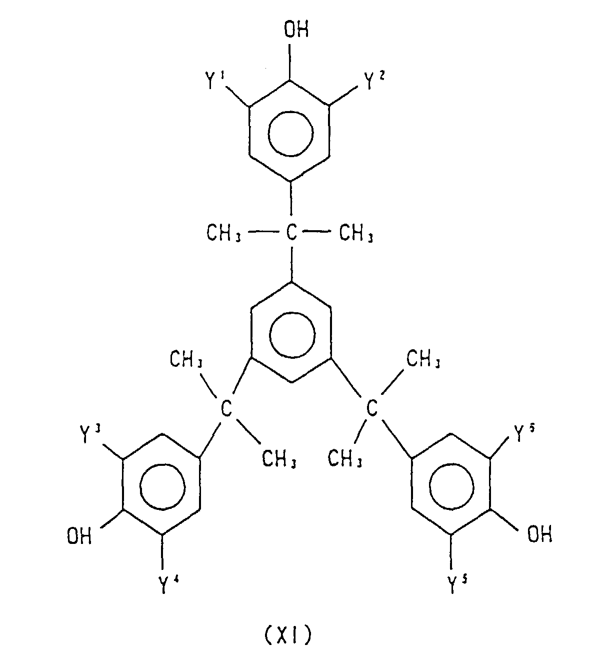 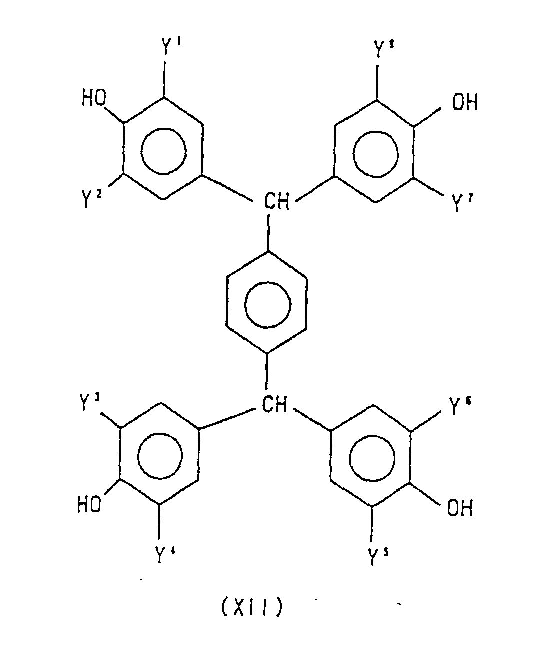 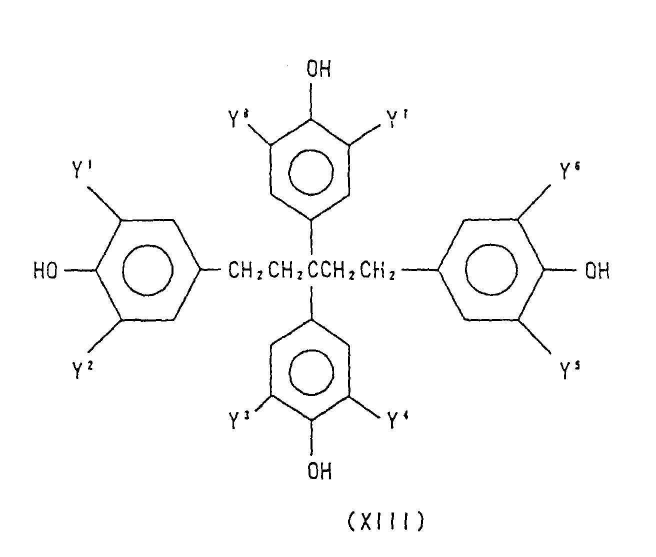 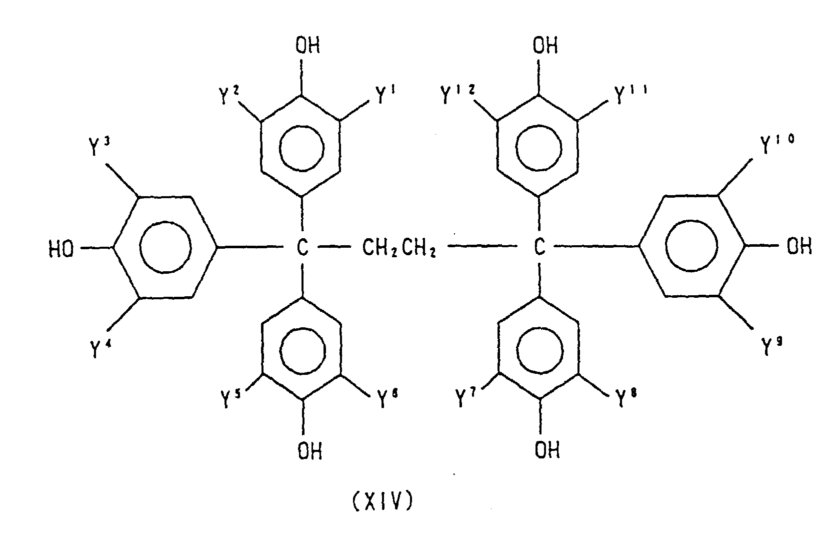 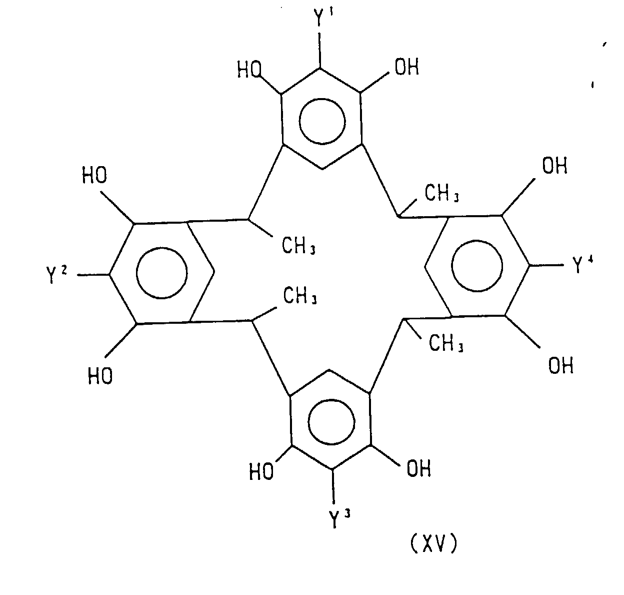 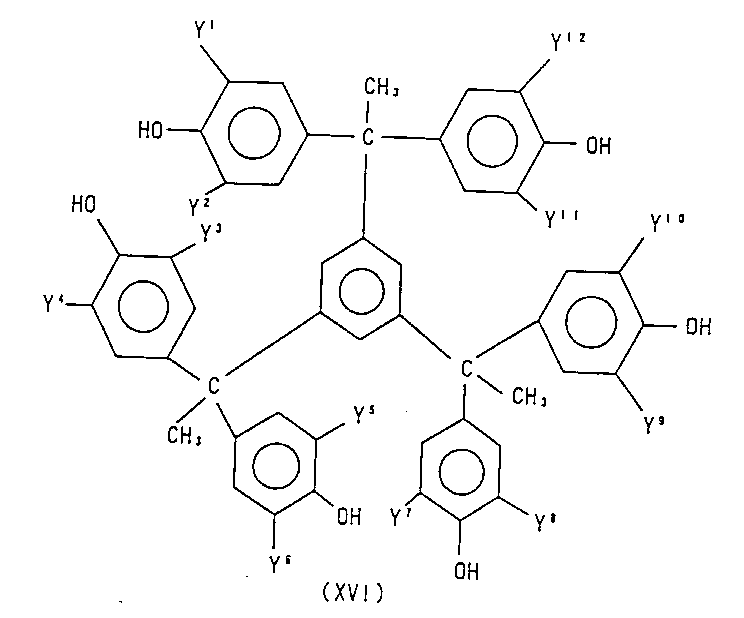 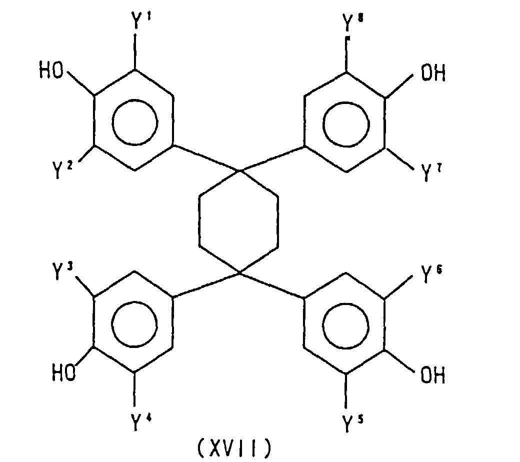 (wherein Y¹ to Y¹² each represents a hydrogen atom or a group represented by Formula (I), provided that at least two of them in each compound represent the groups represented by Formula (I) and preferably all of these substituents represent the groups represented by Formula (I)).

### (II) o-Quinonediazide or Diazonium Salt

The positive-working light-sensitive composition used in the invention in combination with the foregoing phenol derivatives will now be detailed below. The positive-working light-sensitive compositions usable in the invention may be conventionally known light-sensitive compositions comprising o-quinonediazide compounds or diazonium salts. The light-sensitive composition of this type mainly comprises an o-quinonediazide compound or a diazonium salt and an alkali-soluble binder, with those which comprise phenolic resins as the alkali-soluble binders being particularly preferred.

The o-quinonediazide compounds used in the invention are those each having at least one o-quinonediazide group whose solubility in an alkali solution increases through irradiation with actinic light rays and may be compounds having various structures. For instance, the compounds dislosed in J. Koser, "Light-Sensitive Systems", pp. 339-352, John Wiley & Sons, Inc. can be used in the invention, but preferred are sulfonic acid esters or sulfonic acid amides of o-quinonediazide which are reacted with various aromatic polyhydroxy compounds or aromatic amine compounds. Examples of o-quinonediazide compounds suitably used in the invention further include esters of benzoquinone-(1,2)-diazide sulfonic acid chloride or naphthoquinone-(1,2)-diazide sulfonic acid chloride with pyrogallol-acetone resins as disclosed in J.P. KOKOKU No. Sho 43-28403; and esters of benzoquinone-(1,2)-diazide sulfonic acid chloride or naphthoquinone-(1,2)-diazide sulfonic acid chloride with phenol-formaldehyde resins as disclosed in U.S. Patent Nos. 3,046,120 and 3,188,210. Other useful o-quinonediazide compounds are disclosed in a variety of patents such as J.P. KOKAI Nos. Sho 47-5303, Sho 48-63802, Sho 48-63803, Sho 48-96575. Sho 49-38701 and Sho 48-13354; J.P. KOKOKU Nos. Sho 41-11222, Sho 45-9610 and Sho 49-17481; U.S. Patent Nos. 2,797,213, 3,454,400, 3,544,323, 3,573,917, 3,674,495 and 3,785,825; U.K. Patent Nos. 1,227,602, 1,251,345, 1,267,005, 1,329,888 and 1,330,932 and German Patent No. 854,890.

Moreover, examples of the diazonium salts used in the present invention are known ones such as those disclosed in U.S. Patent Nos. 3.219,447 and 3,211,553; J.P. KOKOKU No. Sho 39-7663; J.P. KOKAI No. Sho 52-2519; and J.P.A. No. Hei 3-325859. Examples of particularly effective diazonium salts are those represented by the following general formulas (XVIII), (XIX), (XX) and (XXI):

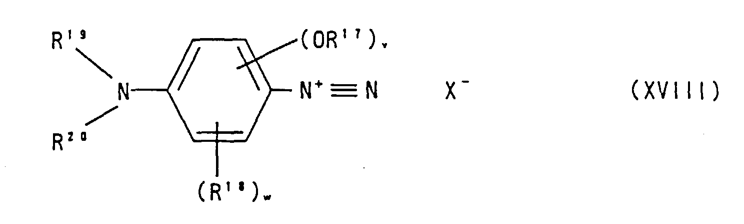

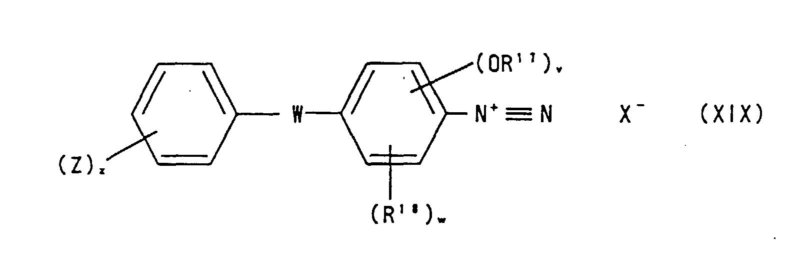

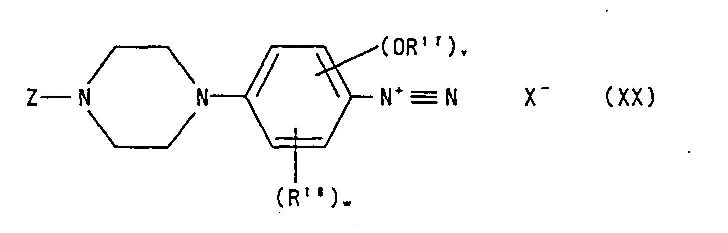

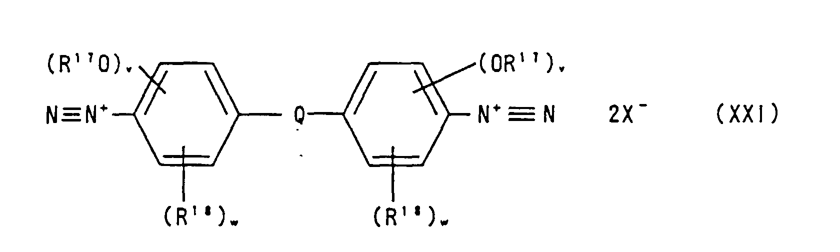

In these general formulas, R¹⁷ represents a substituted or unsubstituted alkyl group having 3 to 18 carbon atoms; R¹⁸ represents a hydrogen atom, a substituted or unsubstituted alkyl group, a substituted or unsubstituted aryl group, a substituted or unsubstituted alkoxy group, a substituted or unsubstituted phenoxy group or a halogen atom; X ⁻ represents a counter anion; v is an integer ranging from 1 to 4 and w is an integer ranging from 1 to 3, provided that the sum of v and w is 4.

R¹⁹ and R²⁰ each independently represent a substituted or unsubstituted alkyl group or a substituted or unsubstituted aryl group, or R¹⁹ and R²⁰ may be bonded together to form a heterocyclic group such as morpholino, piperidino, piperazinyl or pyrrolidinyl group.

W represents an oxygen atom, a sulfur atom, or -NH-, -CH₂-, -CONH- or -C(CH₃)₂- group.

Z represents a hydrogen atom, a substituted or unsubstituted alkyl group, a substituted or unsubstituted aryl group, a substituted or unsubstituted alkoxy group, a substituted or unsubstituted alkylcarbonyl group, a substituted or unsubstituted arylcarbonyl group, a cyano group, a nitro group or a halogen atom, z is an integer ranging from 1 to 5, and Q is a bivalent linking group.

These o-quinonediazide compounds or diazonium salts may be used alone or in combination. The amount of the compound or the salt used in the invention ranges from 1 to 50% by weight, more preferably 5 to 30% by weight on the basis of the total solid content of the light-sensitive composition.

### (III) Compounds Capable of Forming Acid Through Exposure To Light and Compounds Capable of Being Decomposed with Acid

Materials (copying materials) mainly comprising compounds capable of being decomposed by acids may also be used in the composition.

Copying materials of this type are known and disclosed in, for instance. U.S. Patent Nos. 3,779,778 and 4,101,323; German Patent No. 2,718,254; and DEOS Nos. 2,829,512 and 2,829,511. The material comprises an orthocarboxylic acid derivative, a monomeric or polymeric acetal. enol ether or acyliminocarbonate as the compound capable of being decomposed by the action of an acid. The material mainly comprises an organic halogen compound, in particular, an s-triazine substituted with a halogenomethyl group as a compound which is sensitive to light and capable of generating an acid.

Among the orthocarboxylic acid derivatives disclosed in U.S. Patent No. 4,101,324, particularly preferred are bis-1,3-dioxan-2-yl ethers of aliphatic diols.

Among the polyacetals disclosed in German Patent No. 2,718,254, preferably used are those comprising units derived from aliphatic aldehydes and diols.

Further, particularly preferred are those disclosed in DEOS No. 2,928,636. This patent discloses polymeric orthoesters each having orthoester groups repeatedly appearing in the main chain as examples of compounds capable of being decomposed by the action of an acid.

This group is a 2-alkyl ether residue of 1,3-dioxacycloalkane carrying a 5- or 6-membered ring. Particularly preferred are polymers having 1,3-dioxacyclohex-2-yl alkyl ether units (in this case, the alkyl ether group may have an intervening ethereal oxygen atom and is preferably linked to the neighboring ring at the 5-position thereof).

The amount of the compound capable of being decomposed with an acid to be added to the light-sensitive composition in general ranges from 8 to 65% by weight and preferably 14 to 44% by weight on the basis of the total weight of the light-sensitive composition. while the amount of the acid-generating compound ranges from 0.1 to 10% by weight and preferably 0.2 to 5% by weight on the basis of the weight of the light-sensitive composition.

### (IV) Water-Insoluble and Alkali-Soluble Resins

The water-insoluble and alkali-soluble resins used in the invention may be various kinds of resins having such desired properties and preferred are, for instance, novolak resins listed below:

Examples of such novolak resins are, for instance, phenol-formaldehyde resins, cresol/formaldehyde resins such as m-cresol/formaldehyde resins, p-cresol/formaldehyde resins, o-cresol/formaldehyde resins, mixed m-/p-cresol/formaldehyde resins and phenol/cresol (m-/p-/o-, or m-/p-, m-/o- or o-/p-mixed cresol)/formaldehyde resins. Preferred examples are further include resol type phenol resins, with the phenol/cresol (m-/p-/o-, or m-/p-, m-/o- or o-/p- mixed cresol)/formaldehyde resins being preferred and phenol resins disclosed in J.P. KOKAI No. Sho 61-217034 being particularly preferred.

It is also possible to use various alkali-soluble polymeric compounds such as phenol-modified xylene resins, polyhydroxy styrene, halogenated polyhydroxystyrene, acrylic resins comprising phenolic hydroxyl groups as disclosed in J.P. KOKAI No. Sho 51-34711, acrylic resins having sulfonamido groups as disclosed in J.P. KOKAI Hei 2-866 and urethane type resins. These alkali-soluble polymeric compounds each preferably has a weight-average molecular weight ranging from 500 to 200,000 and a number-average molecular weight ranging from 200 to 60,000.

These alkali-soluble polymeric compounds may be used alone or in combination and the amount thereof used in the light-sensitive composition ranges from 5 to 99% by weight and preferably 10 to 90% by weight on the basis of the total solid content of the composition.

### (V) Other Components

In addition, the positive-working light-sensitive composition used in the invention may optionally comprise other various additives.

For instance, it is preferred to simultaneously use a condensate of a phenol carrying an alkyl group having 3 to 8 carbon atoms as a substituent with formaldehyde such as octylphenol/formaldehyde resin for the improvement of the ink receptivity of the resulting images.

Moreover, the light-sensitive composition may comprise cyclic acid anhydrides, phenols and/or organic acids for the improvement of the sensitivity of the resulting composition. Examples of cyclic acid anhydrides are phthalic anhydride, tetrahydrophthalic anhydride, hexahydrophthalic anhydride, 3,6-endoxy-Δ⁴-tetrahydrophthalic anhydride, tetrachlorophthalic anhydride, maleic anhydride, chloromaleic anhydride, α-phenylmaleic anhydride, succinic anhydride and pyromellitic anhydride as disclosed in U.S. Patent No. 4,115,128. Examples of phenols are bisphenol A, p-nitrophenol, p-ethoxyphenol, 2,4,4'-trihydroxybenzophenone, 2,3,4-trihydroxybenzophenone, 4-hydroxybenzophenone, 4,4',4"-trihydroxytriphenylmethane and 4,4',3",4"-tetrahydroxy-3,5,3',5'-tetramethyltriphenylmethane. In addition, organic acids used herein may be sulfonic acids, sulfinic acids, alkylsulfuric acids, phosphonic acids, phosphoric acid esters and carboxylic acids as disclosed in J.P. KOKAI Nos. Sho 60-88942 and Hei 2-96755 and specific examples thereof are p-toluenesulfonic acid, dodecylbenzenesulfonic acid, p-toluenesulfinic acid, ethylsulfuric acid, phenylphosphonic acid, phenylphosphinic acid. phenyl phosphate, diphenyl phosphate, benzoic acid, isophthalic acid, adipic acid, p-toluic acid, 3,4-dimethoxybenzoic acid, phthalic acid, terephthalic acid, 1,4-cyclohexene-2,2-dicarboxylic acid, erucic acid, lauric acid, n-undecanoic acid and ascorbic acid.

The amount of the foregoing cyclic acid anhydrides, phenols and organic acids ranges from 0.05 to 15% by weight and preferably 0.1 to 5% by weight on the basis of the total weight of the light-sensitive composition.

The light-sensitive composition used in the present invention may further comprise nonionic surfactants such as those disclosed in J.P. KOKAI Nos. Sho 62-251740 and Hei 3-208514 and/or amphoteric surfactants such as those disclosed in J.P. KOKAI Nos. Sho 59-121044 and Hei 4-13149 for extending the tolerancy of processing against the conditions for development (development latitude).

Specific examples of nonionic surfactants are sorbitan tristearate, sorbitan monopalmitate, sorbitan trioleate. stearic acid monoglyceride and polyoxyethylene nonylphenyl ether.

Specific examples of amphoteric surfactants are alkyl di(aminoethyl)glycine, alkyl polyaminoethyl glycine hydrochloride, 2-alkyl-N-carboxyethyl-N-hydroxyethyl imidazolinium betaine and N-tetradecyl-N,N-betaine (for instance, a product available from Dai-Ichi Kogyo Seiyaku Co.. Ltd. under the trade name of Amorgen K).

The amount of the foregoing nonionic and amphoteric surfactants used in the light-sensitive composition preferably ranges from 0.05 to 15% by weight and more preferably 0.1 to 5% by weight on the basis of the total weight of the composition.

The light-sensitive composition used in the present invention may also comprise an agent or composition for obtaining a visible image immediately after imagewise exposure to light (a printing out agent) and/or an agent for coloring images such as a dye and a pigment.

Printing out agents are represented by combinations of compounds capable of generating acids through exposure to light (photolytically acid-generating agents) with salt-forming organic dyes. Specific examples thereof are combinations of o-naphthoquinonediazide-4-sulfonic halides with salt-forming organic dyes as disclosed in J.P. KOKAI Nos. Sho 50-36209 and Sho 53-8128; and combinations of trihalomethyl compounds with salt-forming organic dyes as disclosed in J.P. KOKAI Nos. Sho 53-36223, Sho 54-74728, Sho 60-3626, Sho 61-143748, Sho 61-151644 and Sho 63-58440. Examples of such trihalomethyl compounds include oxazol type compounds and triazine type compounds, both of which are excellent in stability with time and can provide clear printed out images.

Agents for coloring images may be salt-forming organic dyes discussed above and other dyes. Examples thereof (inclusive of the salt-forming organic dyes) are oil-soluble dyes and basic dyes. Specific examples thereof are Oil Yellow #101 and #103, Oil Pink #312, Oil Green BG, Oil Blue BOS and #603, Oil Black BY, BS and T-505 (all of these being available from Orient Chemical Industry Co., Ltd.); Victoria Pure Blue, Crystal Violet (CI 42555), Methyl Violet (CI 42535), Ethyl Violet, Rhodamine B (CI 145170B), Malachite Green (CI 42000) and Methylene Blue (CI 52015). In addition, the dyes disclosed in J.P. KOKAI No. Sho 62-293247 are particularly preferred. These dyes can be added to the light-sensitive composition in an amount ranging from 0.01 to 10% by weight and preferably 0.1 to 3% by weight on the basis of the total weight of the solid content of the composition.

Further, the light-sensitive composition used in the invention may optionally comprise a plasticizer for imparting, for instance, flexibility to the resulting film. Examples of plasticizers usable in the invention include butyl phthalyl, polyethylene glycol, tributyl citrate, diethyl phthalate. dibutyl phthalate, dihexyl phthalate, dioctyl phthalate, tricresyl phosphate, tributyl phosphate, trioctyl phosphate, tetrahydrofurfuryl oleate, and oligomers or polymers of (meth) acrylic acid.

### (VI) PS Plate

The positive-working PS plate used in the present invention can be generally prepared by dissolving the foregoing components in a solvent and then applying the resulting solution onto an appropriate substrate. Examples of solvents used herein are ethylene dichloride, cyclohexanone. methyl ethyl ketone, methanol, ethanol, propanol, ethylene glycol monomethyl ether, 2-methoxyethyl acetate, 1-methoxy-2-propyl acetate, dimethoxyethane, methyl lactate, ethyl lactate, N,N-dimethoxyacetamide, N,N-dimethylformamide, tetramethyl urea, N-methylpyrrolidone, dimethylsulfoxide, sulfolane, γ-butyrolactone and toluene.

These solvents may be used alone or in combination. The concentration of the foregoing components (total solid components including additives) in the solvent preferably ranges from 1 to 50% by weight. In addition, the amount of the coated film (solid content) obtained after applying the solution onto the substrate and then drying varies depending on the applications thereof, but preferably ranges from 0.5 to 5.0 g/m² for PS plates. The coated film of the light-sensitive composition may be formed by any method such as bar coater coating, coating with a whirler, spray coating, curtain coating, dip coating, air knife coating, blade coating or roll coating. The smaller the coated amount, the higher the apparent sensitivity of the resulting film, but the lower the properties of the resulting film.

The light-sensitive composition used in the invention may optionally comprise a surfactant for improving the coating properties thereof such as a fluorine atom-containing surfactant as disclosed in J.P. KOKAI No. Sho 62-170950. The amount of the surfactant to be added preferably ranges from 0.01 to 1% by weight and more preferably 0.05 to 0.5% by weight on the basis of the total weight of the light-sensitive composition.

### (VII) Substrate

Substrates usable herein are plate-like materials having high dimensional stability, for instance, paper; paper laminated with a plastic film such as a polyethylene, polypropylene or polystyrene film; metal plates such as aluminum, zinc and copper plates; plastic films such as cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate and polyvinyl acetal films; and paper or plastic films laminated with a foil of the foregoing metal or on which one of the foregoing metals is vapor-deposited.

Among these, particularly preferred are aluminum plates because of high dimensional stability and relatively low price. Preferred aluminum plates are, for instance, those of pure aluminum or an aluminum alloy comprising aluminum as a principal component and a trace amount of other elements as well as plastic films laminated with an aluminum film or on which aluminum is vapor-deposited. Examples of the trace elements included in the aluminum alloys are silicon, iron, manganese, copper, magnesium, chromium, zinc, bismuth, nickel and/or titanium. The amount of these trace elements present in the aluminum alloy is at most 10% by weight. Particularly preferred aluminum substrate used in the invention is a pure aluminum plate, but it is presently difficult to obtain a completely pure aluminum plate from the viewpoint of refining technique. Therefore, an aluminum plate containing other elements in a trace amount may be employed. As has been described above, the aluminum plates usable in the invention are not restricted to those having specific compositions and may be those commonly known and used in this art. The aluminum plate used in the invention has a thickness in the order of about 0.1 to 0.6 mm.

The aluminum plate is in general surface-roughened. The plate is, if desired, degreased by treating with, for instance, a surfactant solution, an organic solvent or an alkaline aqueous solution for the removal of the rolling oils present on the surface thereof, prior to a surface-roughening treatment.

The surface-roughening treatment of the aluminum plate can be carried out according to various methods such as a method comprising mechanically surface-roughening the plate, a method comprising surface-roughening the plate by electrochemically dissolving the surface thereof and a method comprising selectively dissolving the surface of the plate through a chemical means. Examples of the mechanical methods include those known ones such as ball-graining, brush-graining, blast-graining and buff-graining methods. In addition, examples of electrochemical surface-roughening treatments are those comprising electrochemically surface-roughening the plates in an electrolyte such as a hydrochloric acid or nitric acid solution. Moreover, it is also possible to use a combination of these methods as disclosed in J.P. KOKAI No. Sho 54-63902.

The aluminum plate thus surface-roughened is, if desired, subjected to an etching treatment with an alkali and/or a neutralization treatment and, thereafter, optionally anodized for the improvement of the water retention characteristics and the wear resistance of the surface. As electrolytes used in the anodization of the aluminum plate, there may be used, for instance, various kinds of electrolytes capable of forming porous anodized layers on the aluminum plate, such as sulfuric acid, phosphoric acid, oxalic acid, chromic acid or mixture thereof. The concentration of these electrolytes may properly be determined depending on the kinds of electrolytes selected.

Conditions for the anodization may variously vary depending on the kinds of electrolytes used and cannot be determined specifically, but are currently and suitably an electrolyte concentration ranging from 1 to 80% by weight, an anodization temperature ranging from 5 to 70 °C, a current density ranging from 5 to 60 A/dm², an electric voltage ranging from 1 to 100 V and an electrolyzation time ranging from 10 seconds to 5 minutes.

The amount of the anodized layer thus formed must be not less than 1.0 g/m². This is because, if the amount of the anodized layer is less than 1.0 g/m², the printing durability of the resulting lithographic printing plate is insufficient, the non-image area of the lithographic printing plate is easily damaged and this often leads to so-called "contamination due to defects", i.e., adhesion of an ink to the damaged portion during printing operations.

After anodization, the surface of the aluminum plate is, if desired, hydrophilized. The hydrophilization treatments usable in the invention include, for instance, an alkali metal silicate treatment (for instance, a treatment with an aqueous solution of sodium silicate) as disclosed in U.S. Patent Nos. 2,714,066. 3,181,461, 3,280,734 and 3,902,734. In this method, a substrate is immersed or electrolyzed in an aqueous solution of sodium silicate. Examples of other hydrophilization methods usable herein include a treatment with a potassium fluorozirconate solution as disclosed in J.P. KOKOKU No. Sho 36-22063; and a treatment with a polyvinyl phosphonic acid solution as disclosed in U.S. Patent Nos. 3,276,868, 4,153,461 and 4,689,272.

### (VIII) Underlying Coating Layer and Mat Layer

The positive-working PS plate used in the present invention comprises a substrate provided thereon with a layer of a positive-working light-sensitive composition, but the PS plate may additionally comprise an underlying layer positioned between the substrate and the light-sensitive layer as well as a mat layer on the light-sensitive layer.

Such an underlying layer may be formed from various organic compounds, for instance, carboxymethyl cellulose, dextrin, gum arabic, phosphonic acids having an amino group such as 2-aminoethylphosphonic acid, organic phosphonic acids which may have substituents such as phenylphosphonic acid. naphthylphosphonic acid, alkylphosphonic acid, glycerophosphonic acid, methylenediphosphonic acid and ethylenediphosphonic acid, organic phosphoric acids which may have substituents such as phenylphosphoric acid, naphthylphosphoric acid, alkylphosphoric acid and glycerophosphoric acid, organic phosphinic acids which may have substituents such as phenylphosphinic acid, naphthylphosphinic acid, alkylphosphinic acid and glycerophosphinic acid, amino acids such as glycine and β-alanine, and hydrochlorides of amines carrying hydroxyl groups such as triethanolamine hydrochloride. These organic compounds may be used alone or in combination to form an underlying layer.

This organic underlying layer can be applied to the substrate by the following manner, for instance, a method comprising dissolving the foregoing organic compound in a solvent, for instance, water, an organic solvent such as methanol, ethanol or methyl ethyl ketone or mixture thereof, applying the resulting solution onto an aluminum plate and then drying; or a method comprising dissolving the foregoing organic compound in a solvent, for instance, water, an organic solvent such as methanol, ethanol or methyl ethyl ketone or mixture thereof, dipping an aluminum plate in the resulting solution to adsorb the compound on the plate, then washing it with, for instance, water and drying. In the former method, a solution of the foregoing organic compound having a concentration ranging from 0.05 to 10% by weight can be applied by a variety of coating methods, while in the latter method, the concentration of the dipping solution ranges from 0.01 to 20% by weight, preferably 0.05 to 5% by weight, the dipping temperature ranges from 20 to 90°C, preferably 25 to 50 °C and the dippintg time ranges from 0.1 second to 20 minutes, preferably 2 seconds to one minute. The pH value of the dipping solution may be adjusted to 1 to 12 by addition of a basic substance such as ammonia, triethylamine or potassium hydroxide or an acidic substance such as hydrochloric acid or phosphoric acid. In addition, a yellow dye may be added to the dipping solution for the improvement in the tone reproduction of the resulting PS plate.

The amount of the organic underlying layer to be applied is suitably in the range of from 2 to 200 mg/m² and preferably 5 to 100 mg/m². This is because if the coated amount of the compound is less than 2 mg/m², the resulting lithographic printing Plate never exhibits sufficient printing durability. In addition, if it exceeds 200 mg/m², the same problem arises.

A mat layer is applied onto the surface of the positive-working light-sensitive layer used in the invention for shortening the evacuation time during the contact exposure in a vacuum printing frame and for preventing the formation of an indistinct image during printing. Specific mat layer-forming methods include. for instance, those disclosed in J.P. KOKAI No. Sho 50-125805 and J.P. KOKOKU Nos. Sho 57-6582 and Sho 61-28986 and a method comprising heat-fusing solid powder onto the surface of the light-sensitive layer as disclosed in J.P. KOKOKU No. Sho 62-62337.

The average diameter of projections formed on the mat layer is preferably not more than 100 µm, more preferably 2 to 8 µm. If the average diameter exceeds the upper limit, the formation of fineline images becomes difficult, the dot density in highlight portions decreases and the tone reproduction is also impaired. On the other hand. if the average diameter is less than 2 µm, the resulting PS plate is insufficient in the adhesion under vacuum and suffers from a problem of the formation of an indistinct image during printing. The amount of the coated mat layer preferably ranges from 5 to 200 mg/m² and more preferably 20 to 150 mg/m². If the amount of the coated mat layer exceeds the upper limit, scratch marks are easily formed on the resulting PS plates, while if it is less than the lower limit, the PS plate is insufficient in the adhesion under vacuum during printing.

### (IX) Developer

The positive-working PS plate thus prepared is in general imagewise exposed to light and then developed to give a lithographic printing plate.

In the imagewise exposure step, a mercury lamp, a metal halide lamp. a xenon lamp, a chemical lamp or a carbon arc lamp can be used as a source for actinic light rays. Moreover, radiant rays can likewise be used for the imagewise exposure of the PS plate, for instance, electron rays, X-rays, ion beams and far infrared rays. It is also possible to use g-rays, i-rays, Deep-UV light rays and high density energy beams (laser beams). Examples of laser beams are He • Ne laser, Ar laser, Kr laser, He • Cd laser and KrF excimer laser beams.

Developers and replenishers for the positive-working PS plate used in the present invention may be those conventionally known alkaline aqueous solutions. Examples of alkalis used in the developers or replenishers include inorganic alkali salts such as sodium silicate, Potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium bicarbonate, potassium bicarbonate, ammonium bicarbonate, sodium borate, potassium borate, ammonium borate, sodium hydroxide, ammonium hydroxide, potassium hydroxide and lithium hydroxide. Examples of alkalis usable in the developers or replenishers further include organic alkaline agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine and pyridine.

In the developers and replenishers used herein, these alkaline agents may be used alone or in combination.

Among these developers comprising the foregoing alkaline agents, particularly preferred are aqueous solutions of silicates such as sodium silicate and potassium silicate. This is because, the developing ability thereof can be controlled by properly adjusting the rate of silicon oxide, SiO₂ to the alkali matal oxide, M₂O which are components of the silicate and the concentrations thereof and effectively used in the invention are, for instance, alkali metal silicates as disclosed in J.P. KOKAI No. Sho 54-62004 and J.P. KOKOKU No. Sho 57-7427.

Moreover, it has been known that, if the development is performed using an automatic developing machine, a large number of PS plates can be processed over a long time without exchanging the developer in a developing tank by supplementing an aqueous solution (a replenisher) having an alkali concentration higher than that of the developer. This supplementation system can likewise be preferably used in the present invention.

Various kinds of surfactants and/or organic solvents may, if necessary, be added to the developer and replenisher used in the present invention for promoting or restraining development, for improving the dispersibility of insoluble compounds formed during development and for the improvement of the ink receptivity of images of the resulting lithographic printing plate. Preferred surfactants are, for instance, anionic, cationic, nonionic and amphoteric surfactants.

The developer and replenisher used herein may, if desired, comprise other additives, for instance, reducing agents such as hydroquinone, resorcin, sodium salts and potassium salts of inorganic acids such as sulfurous acid and hydrogensulfurous acid, organic carboxylic acids, antifoaming agents and/or water softeners.

The PS plate developed with the foregoing developer and replenisher is then subjected to post-treatments with, for instance, washing water, a rinsing solution containing, for instance, a surfactant and/or a desensitization solution containing gum arabic or a starch derivative. Any combination of these treatments can be used as the post-treatment for the PS plate used in the present invention.

Recently, there have been used automatic developing machines for PS plates for rationalization and standardization of the plate-making operations in the fields of plate-making and printing industries. The automatic developing machine of this type generally comprises a developing zone and a posttreatment zone, more specifically it comprises a device for conveying PS plates, baths filled with various processing solutions and spray devices, wherein an imagewise exposed PS plate is developed by spraying each processing solution, sent up by a pump, thereon through a spray nozzle while the PS plate is horizontally conveyed. Alternatively, there has recently been known a method in which an imagewise exposed PS plate is developed by conveying it while the plate is dipped in a bath filled with a processing solution through the action of dipped guide rolls. In such an automatic processing, the PS plate can be processed while supplementing replenishers to the corresponding processing baths in proportion to the amount of the processed PS plates and the operation time.

The PS plate used in the present invention can likewise be processed by the so-called disposable processing method in which the plate is processed in a substantially fresh processing solution.

If there are unnecessary image portions (for instance, edge marks of an original film formed during imagewise exposure) on the lithographic printing plate prepared by imagewise exposing the PS plate used in the invention, developing, water-washing and/or rinsing and gumming up, the unnecessary image portions are deleted. The deletion of this type is preferably carried out by applying a deletion liquid such as those disclosed in J.P. KOKOKU No. Hei 2-13293 onto the unnecessary image portions, then allowing to stand over a predetermined time period and washing with water. Alternatively, it is also possible to use a method comprising irradiating the unnecessary image portions with actinic light rays guided through an optical fiber and then developing as disclosed in J.P. KOKAI No. Sho 59-174842.

### (X) Burning Treatment

The lithographic printing plate thus prepared is, if desired, coated with a desensitizing gum and then used in printing operations, but if it is required for the preparation of a lithographic printing plate having more higher printing durability, the resulting printing plate is subjected to a burning treatment.

When burning a lithographic printing plate, it is preferably treated with a surface-conditioning solution such as those disclosed in J.P. KOKOKU Nos. 61-2518 and Sho 55-28062 and J.P. KOKAI Nos. Sho 62-31859 and Sho 61-159655 prior to the burning treatment.

This surface-conditioning treatment can be performed by applying the surface-conditioning solution onto the lithographic printing plate with a sponge or absorbent wadding containing the solution, by immersing the plate in a vat filled with the surface-conditioning solution, or applying the surface-conditioning solution using an automatic coater. After the application of the surface-conditioning solution, the plate is preferably treated by a squeezee or squeezee rolls for making the coated amount of the solution uniform and this ensures an optimum result.

In general, the amount of the surface-conditioning solution to be applied desirably ranges from 0.03 to 0.8 g/m² (weighed after drying).

After optionally drying the lithographic printing plate to which the surface-conditioning solution has been applied, the plate is heated to a high temperature in a burning processor (such as Burning Processor: BP-1300 available from Fuji Photo Film Co., Ltd.). The heating temperature and time during the burning treatment vary depending on the kinds of image forming-components, but in general range from 180 to 300°C and 1 to 20 minutes, respectively.

After the burning treatment, the lithographic printing plate is, if necessary, subjected to appropriate posttreatments conventionally used such as water washing and gumming treatments. However, if a surface-conditioning solution comprising, for instance, a water-soluble polymer is used, the so-called desensitization such as a gumming up step can be omitted.

The lithographic printing plate thus obtained is fitted to, for instance, an offset printing press to give a large number of copies.

The PS plate used in the present invention never causes ink spreading due to burning treatment even when it is burned at a high temperature, has wide development latitude, is excellent in ink receptivity and can provide a lithographic printing plate having excellent printing durability.

The present invention will hereinafter be described in more detail with reference to the following working Examples and the effects of the present invention practically attained will also be discussed in detail in comparison with Comparative Examples.

### Preparation Example 1: Preparation of Compound (X)

To a 1ℓ volume egg-plant type flask, there were added 42.4 g (0.10 mole) of 1-[α-methyl-α-(4-hydroxyphenyl)ethyl]-4-[α,α-bis(4-hydroxyphenyl)ethyl]benzene, 19.6 g (0.35 mole) of potassium hydroxide and 250 ml of water and then 120 ml (1.5 mole) of an aqueous solution of formalin (37%) was added to the mixture, followed by stirring at 50°C for 8 hours. After completion of the reaction, the reaction system was poured in 1250 ml of ice-water containing 33.3 ml (0.4 mole) of a conc. hydrochloric acid to precipitate white powder. After filtering off the white powder and washing it with water, the white powder was recrystallized from a 1:1 methanol/methyl ethyl ketone mixture to give 54.8 g of a hexamethylol derivative of 1-[α-methyl-α-(4-hydroxyphenyl)ethyl]-4-[α,α-bis(4-hydroxyphenyl)ethyl]benzene (a compound of Formula (X) wherein all of the substituents Y¹ to Y⁶ are methylol groups).

The resulting compound had a purity of 99.2% as determined by liquid chromatography and was confirmed to be a hexamethylol derivative by NMR analysis.

### Preparation Example 2: Preparation of Compound (XI)

To a 1ℓ volume egg-plant type flask, there were added 48.1 g (0.10 mole) of α,α',α"-tris(4-hydroxyphenyl)-1,3,5-triisopropylbenzene, 16.0 g (0.40 mole) of sodium hydroxide and 300 ml of water and then 145 ml (1.8 mole) of an aqueous solution of formalin (37%) was added to the mixture, followed by stirring at room temperature for 12 hours. After completion of the reaction, the reaction system was poured in 1500 ml of ice-water containing 40 ml (0.48 mole) of a conc. hydrochloric acid to precipitate white powder. After filtering off the white powder and washing it with water, the white powder was recrystallized from a 2:3 methanol/methyl ethyl ketone mixture to give 60.5 g of a methylol derivative of α,α',α"-tris(4-hydroxyphenyl)-1,3,5-triisopropylbenzene (a compound of Formula (XI)).

The resulting compound was found to have a rate of methylol groups in the substituents Y of Formula (XI) of 95% as determined by NMR analysis.

### Examples 1 to 8 and Comparative Examples 1 to 7

After degreasing an aluminum plate (aluminum 1050) having a thickness of 0.3 mm through washing with trichloroethylene, the plate was surface-grained using a nylon brush and an aqueous suspension of 400 mesh pumice stone and then sufficiently washed with water. The plate was etched by immersing in a 25% aqueous sodium hydroxide solution maintained at 45 °C for 9 second and then washed with water, followed by immersion thereof in a 20% nitric acid solution for 20 seconds and water-washing. At this stage, the amount of the aluminum removed from the plate surface through the etching was about 3 g/m². Then the plate was anodized at a current density of 15 A/dm² in a 7% sulfuric acid solution as an electrolyte to form 3 g/m² of a DC-anodized layer, followed by water-washing and drying. Thereafter, an underlying coating solution having the following composition was applied onto the aluminum plate and dried at 80 °C for 30 seconds. The coated amount of the underlying coating solution (weighed after drying) was found to be 10 mg/m².

| (Underlying Coating Solution) | |
|---|---|
| β-alanine | 0.1 g |
| phenylphosphonic acid | 0.05 g |
| methanol | 40 g |
| pure water | 60 g |

Moreover, a light-sensitive solution having the following composition was applied onto the aluminum plates thus treated and then dried at 100 °C for 2 minutes to give a series of positive-working PS plates. The coated amount of the light-sensitive solution for each PS plate was found to be 2.0 g/m² (weighed after drying).

| Light-Sensitive Solution | |
|---|---|
| Component | Amount (g) |
| ester *¹ of naphthoquinone-1,2-diazide-5-sulfonic acid chloride with pyrogallol/acetone resin | 0.90 |
| cresol/formaldehyde novolak (m-:p- ratio =6:4; weight-average molecular weight=1800; unreacted cresol content of 0.5%) | (see Table 1) |
| p-octylphenol/formaldehyde novolak | 0.02 |
| naphthoquinone-1,2-diazide-5-sulfonic chloride | 0.01 |
| phenol derivative | (see Table 1) |
| tetrahydrophthalic anhydride | 0.05 |
| 4-(p-N,N-bis(ethoxycarbonylmethyl)aminophenyl)-2,6-bis-(trichloromethyl)-s-triazine | 0.02 |
| 4-(p-N-(p-hydroxybenzoyl)aminophenyl)-2,6-bis-(trichloromethyl)-s-triazine | 0.02 |
| dye (Victoria Pure Blue BOH whose counter ion was exchanged to a 1-naphthalenesulfonate ion) | 0.03 |
| Megafac F-177 (a fluorine atom-containing surfactant available from Dainippon Ink and Chemicals, Inc.) *² | 0.06 |
| methyl ethyl ketone *³ | 12 |
| 2-methoxy-1-propanol*⁴ | 15 |

| | |
|---|---|
| *1: An ester of naphthoquinone-1,2-diazide-4-sulfonic chloride with a pyrogallol/acetone resin was used in Example 3. | |
| *2: In Example 1, 0.15 g of Megafac F-177 was used. | |
| *3: In Example 1, 25 g of methyl ethyl ketone was used. | |
| *4: In Example 1, 2-methoxy-1-propanol was not used. | |

**Table 1**

| Ex. No. | Amount of cresol/formaldehyde novolak Used (g) | Phenol Derivatives Used | | |
|---|---|---|---|---|
| | | General Formula | Rate of CH₂OH Groups In Y (%) | Amount Used(g) |
| 1 | 2.10 | (X) | 100 | 0.06 |
| 2 | 2.105 | (XI) | 95 | 0.055 |
| 3 | 2.10 | (XII) | 85 | 0.06 |
| 4 | 2.00 | (XIII) | 65 | 0.16 |
| 5 | 2.085 | (XIV) | 80 | 0.075 |
| 6 | 2.06 | (XV) | 100 | 0.10 |
| 7 | 2.04 | (XVI) | 90 | 0.12 |
| 8 | 2.08 | (XVII) | 95 | 0.08 |
| 1 * | 2.16 | -- | -- | -- |
| 2 * | 2.10 | (XXII) | | 0.06 |
| 3 * | 1.76 | (XXII) | | 0.40 |
| 4 * | 2.06 | (XXIII) | | 0.10 |
| 5 * | 1.66 | (XXIII) | | 0.50 |
| 6 * | 2.08 | (XXIV) | | 0.08 |
| 7 * | 1.71 | (XXIV) | | 0.45 |

| | | | | |
|---|---|---|---|---|
| *: Comparative Example | | | | |

Compounds (XXII), (XXIII) and (XXIV) used in Comparative Examples are represented by the following general formulas (XXII), (XXIII) and (XXIV) each having 1 to 3 benzene nuclei. Compounds (XXII) and (XXIII) are those disclosed in Examples of the patent: J.P. KOKOKU No. Hei 1-49932.

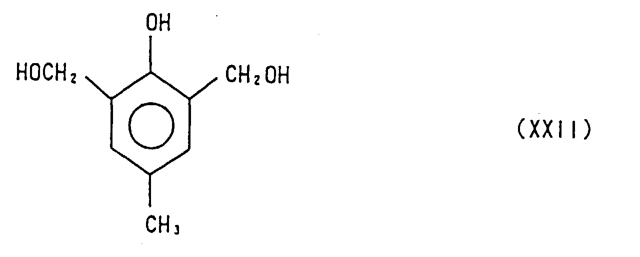

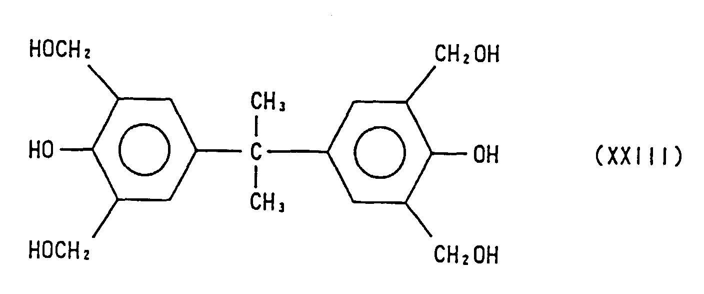

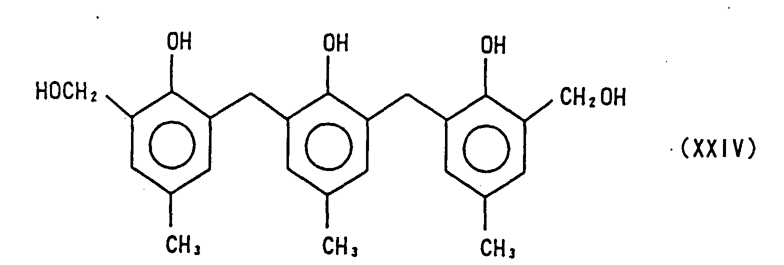

These positive-working PS plates each was exposed to light from a 30 A carbon arc lamp at a distance of 70 cm and then developed with DP-4 (trade name of a developer available from Fuji Photo Film Co., Ltd.) diluted 8 times at 25 °C for 40 seconds using an automatic developing machine (800U; available from Fuji Photo Film Co., Ltd.). In this respect, the optimum exposure time was defined to be an instance at which the 5th stage of a gray scale (available from Fuji Photo Film Co., Ltd.) having a density difference of 0.15 became completely clear and the time required for achieving the optimum exposure was defined to be the sensitivity of each corresponding PS plate. In addition, there was determined the time (hereinafter referred to as "development latitude") required for developing additional two stage of the gray scale beyond the number of solid steps thereof observed when it was vat-developed at 25 °C for 40 seconds with DP-4 diluted 8 times.

In a vacuum printing frame, these PS plates each was then imagewise exposed to light from a halide lamp on a transparent base through a positive original film over 60 seconds and then developed in an automatic developing machine in which a developer DP-4 (diluted 8 times) and a rinsing solution FR-3 (diluted 7 times) (both available from Fuji Photo Film Co., Ltd.) were introduced into corresponding tanks respectively. Then the plate surface was treated with a gumming solution GU-7 (1:1; available from Fuji Photo Film Co., Ltd.), allowed to stand for one day and fitted to a printing press, Heidelberg KOR-D, to give copies. The number of copies (ink receptivity) required for obtaining a copy exhibiting good acceptable quality was determined and listed in Table 2 given below.

Subsequently, these PS plates each was, in a vacuum printing frame, imagewise exposed to light from a halide lamp on a transparent base through a positive original film over 60 seconds and then developed in an automatic developing machine in which a developer DP-4 (diluted 8 times) and a rinsing solution FR-3 (diluted 7 times) (both available from Fuji Photo Film Co., Ltd.) ) were introduced into corresponding tanks respectively. Further the plate surface was treated with a surface-conditioning solution BC-3 (available from Fuji Photo Film Co., Ltd.) for burning and treated in a burning device, BP-1300 for 7 minutes. Then the plate surface was treated with a gumming solution GU-7 (diluted 2 times with water; available from Fuji Photo Film Co., Ltd.), allowed to stand for one day and fitted to a printing press, Heidelberg KOR-D, to give copies. The burning temperature, the number of copies obtained and the extent of ink spreading (I.S.) in half tone dot images are summarized in the following Table 2.

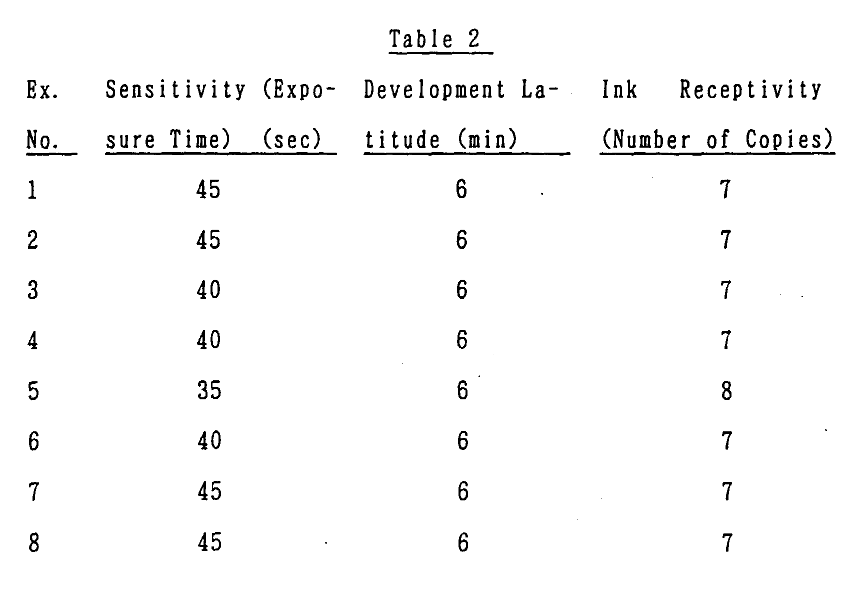

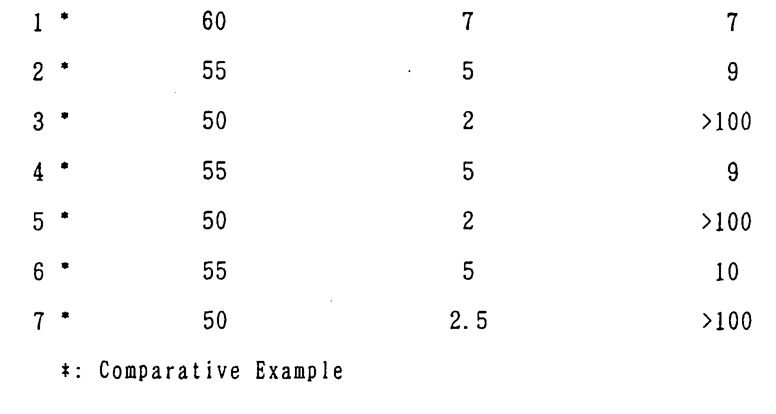

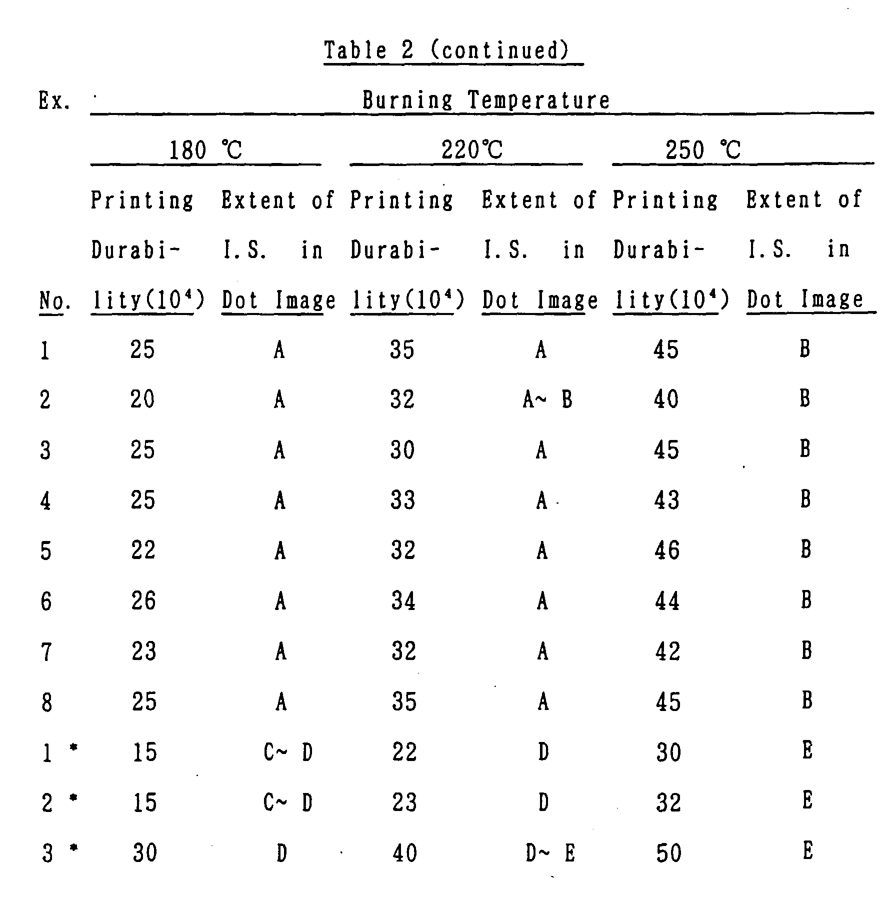

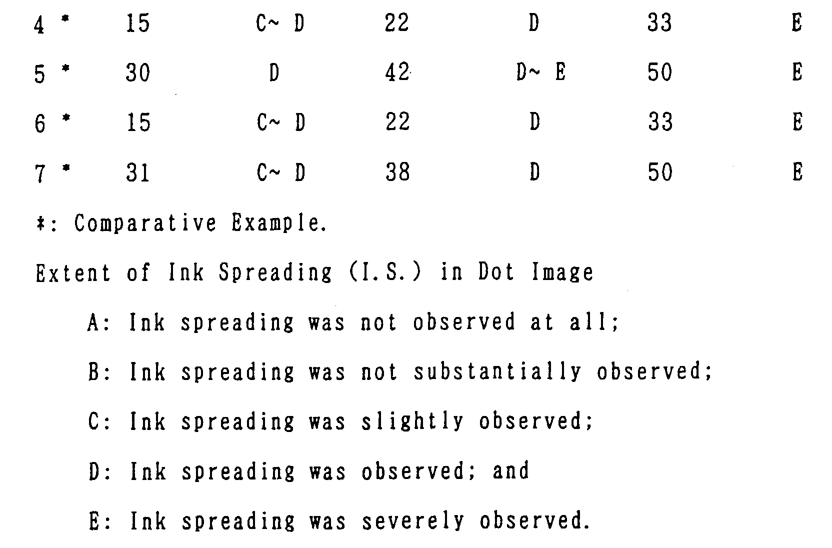

The results listed in Table 2 indicate that the PS plates of Examples 1 to 8 used according to the present invention in which phenol derivatives were used in the light-sensitive layer never caused contamination of non-image areas and had improved printing durability, as compared with the PS plate of Comparative Example 1 in which any phenol derivative was not used, irrespective of the burning temperature. On the other hand, the PS plates of Comparative Examples 2 to 5 in which compounds disclosed in J.P. KOKOKU No. Hei 1-49932 were used did not show any effect of eliminating contamination of non-image areas and only a printing durability-improving effect was observed for these PS plates of Comparative Examples 3 and 5 in which the compounds were used in large amounts.

Moreover, the PS plates of Examples 1 to 8 used according to the present invention in which phenol derivatives were used in the light-sensitive layer had improved sensitivity (short optimum exposure time) superior to that of the PS plate of Comparative Example 1, while the development latitude thereof was slightly deteriorated. However, any practical problem does not arise. On the other hand, the compounds disclosed in J.P. KOKOKU No. Hei 1-49932 and used in the PS plates of Comparative Examples 2 to 5 slightly showed an effect of improving sensitivity, but resulted in substantial reduction in the development latitude of the resulting PS plates.

Moreover, the PS plates of Comparative Examples 3 and 5 whose printing durability was improved through the use of the compounds disclosed in J.P. KOKOKU No. Hei 1-49932 showed severe deterioration of ink receptivity and formed a great deal of paper waste during printing operations.

The foregoing clearly indicate that the phenol derivatives used in the PS plate used according to the present invention never cause substantial reduction in the development latitude, can impart high sensitivity to the resulting PS plate, does not impair the ink receptivity, substantially reduce contamination of non-image areas during burning at any temperature and can improve the printing durability of the resulting PS plate.

### Examples 9 to 16 and Comparative Examples 8 to 15

The same procedures used in Example 1 were repeated except that, in the light-sensitive solution used in Example 1, compounds listed in the following Table 3 were substituted for 2.10 g of cresol/formaldehyde novolak to give PS plates.

**Table 3:**

| Composition Corresponding to 2.10 g of Cresol/Formaldehyde Novolak (m-:p- ratio=6:4) Used in Example 1 | | |
|---|---|---|
| Example 9 | cresol/formaldehyde novolak (m-/p- ratio= 6:4; weight-average molecular weight=3150; unreacted cresol content=0.6%) | 2.10g |
| Example 10 | cresol/formaldehyde novolak (m-/p- ratio= 6:4; weight-average molecular weight=1800; unreacted cresol content=0.5%) | 1.80g |
| | m-cresol/formaldehyde novolak (weight-average molecular weight=2200) | 0.30g |
| Example 11 | cresol/formaldehyde novolak (m-/p- ratio= 6:4; weight-average molecular weight=1800; unreacted cresol content=0.5%) | 1.30g |
| | phenol/p-cresol-formaldehyde novolak (phenol/cresol ratio=4/6; weight-average molecular weight=1200; unreacted cresol content=1.2%) | 0.80g |
| Example 12 | phenol/cresol-formaldehyde novolak (phenol/m-/p- ratio=40:36:24; weight-average molecular weight=6200) | 2.10g |
| Example 13 | phenol/cresol-formaldehyde novolak (phenol/m-/p- ratio=40:36:24; weight-average molecular weight=1500) | 2.10g |
| Example 14 | cresol/formaldehyde novolak (m-/p- ratio= 6:4; weight-average molecular weight=1800; unreacted cresol content=0.5%) | 1.50g |
| | phenol/p-cresol-formaldehyde resol (phenol/cresol ratio=9/1; weight-average molecular weight=1400; free of -CH₂OH group) | 0.60g |
| Example 15 | cresol/formaldehyde novolak (m-/p- ratio= 6:4; weight-average molecular weight=1800; unreacted cresol content=0.5%) | 1.80g |
| | N-(p-aminosulfonylphenyl)acrylamide/n-butyl acrylate/diethylene glycol monomethyl ether methacrylate (40/40/20) copolymer | 0.30g |
| Example 16 | cresol/formaldehyde novolak (m-/p- ratio= 6:4; weight-average molecular weight=1800; unreacted cresol content=0.5%) | 1.85g |
| | p-hydroxyphenyl methacrylamide/benzyl acrylate/2-hydroxyethyl methacrylate (40/30/30) copolymer | 0.25g |

Moreover, the same procedures used above were repeated except that the corresponding amount of cresol-formaldehyde novolak (m-/p- ratio=6:4; weight-average molecular weight = 1800; unreacted cresol content = 0.5%) was substituted for the compound of Formula (X) used in Examples 9 to 16 to give comparative PS plates (Comparative Examples 8 to 15) whose light-sensitive layers were free of phenol derivatives.

Each PS plate thus prepared was subjected to a burning treatment and then fitted to a printing press to give copies in the same manner used in Example 1. The results thus obtained are summarized in the following Table 4.

**Table 4**

| Ex.No. | Burning Temperature | | | | | |
|---|---|---|---|---|---|---|
| | 180 °C | | 220°C | | 250 °C | |
| | Printing Durability(10⁴) | Extent of I.S. in Dot Image | Printing Durability(10⁴) | Extent of I.S. in Dot Image | Printing Durability(10⁴) | Extent of I.S. in Dot Image |
| 9 | 25 | A | 35 | A | 44 | A∼ B |
| 8 * | 16 | C∼ D | 22 | D | 30 | E |
| 10 | 25 | A | 35 | A | 45 | B |
| 9 * | 15 | C∼ D | 22 | D | 30 | E |
| 11 | 28 | A | 42 | A∼ B | 50 | B |
| 10* | 18 | D | 27 | E | 35 | E |
| 12 | 25 | A | 34 | A∼ B | 40 | B |
| 11 * | 15 | C∼ D | 23 | D∼ E | 30 | E |
| 13 | 26 | A | 36 | A∼ B | 40 | B |
| 12* | 15 | C∼ D | 22 | D∼ E | 30 | E |
| 14 | 26 | A∼ B | 44 | B | 55 | B |
| 13* | 18 | D | 27 | E | 35 | E |
| 15 | 20 | A | 26 | A | 38 | A∼ B |
| 14* | 18 | C∼ D | 24 | D | 30 | E |
| 16 | 20 | A | 28 | A | 38 | A∼ B |
| 15* | 18 | C∼ D | 24 | D | 30 | E |

| | | | | | | |
|---|---|---|---|---|---|---|
| *: Comparative Example. | | | | | | |

The results listed in Table 4 indicate that the PS plates of Examples 9 to 16 (present invention) in which phenol derivatives were used in the light-sensitive layer are quite excellent products. In other words, these PS plates permit the substantial reduction of contamination of non-image areas during burning and the improvement in the printing durability irrespective of the kinds of binders used and temperatures, as compared with the PS plates of Comparative Examples 8 to 15 which were free of phenol derivatives.

## Claims

1. Use of a positive-working presensitized plate for making a lithographic printing plate, said positive-working presensitized plate comprising a substrate provided thereon with a light-sensitive layer, wherein the light-sensitive layer is formed from a positive-working light-sensitive composition comprising a phenol derivative, a water-insoluble and alkaline water-soluble resin and an o-quinonediazide or a diazonium salt or a mixture of a compound capable of forming an acid through exposure to light with a compound having at least one C-O-C group capable of being decomposed by the action of the acid, said phenol derivative and said water-insoluble and alkaline water-soluble resin being different from each other, said phenol derivative being at least one member selected from the group consisting of those represented by the following general formulas (II) to (IX): 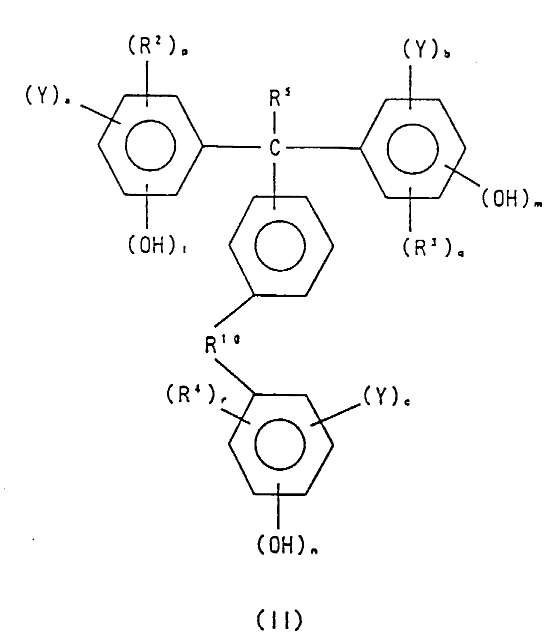 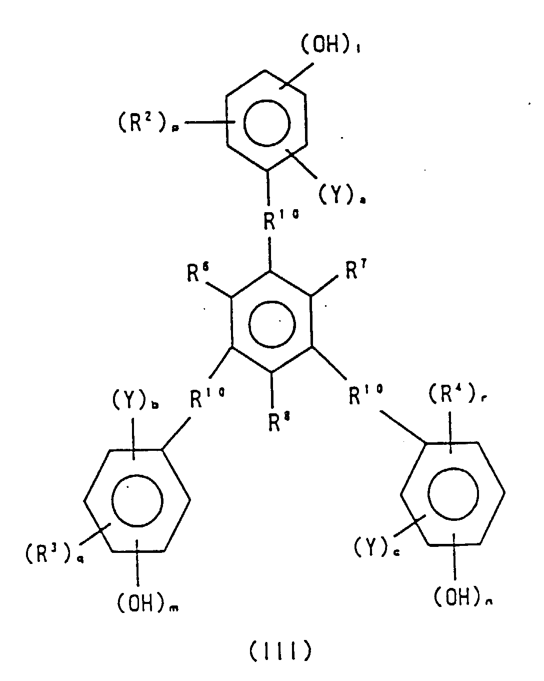 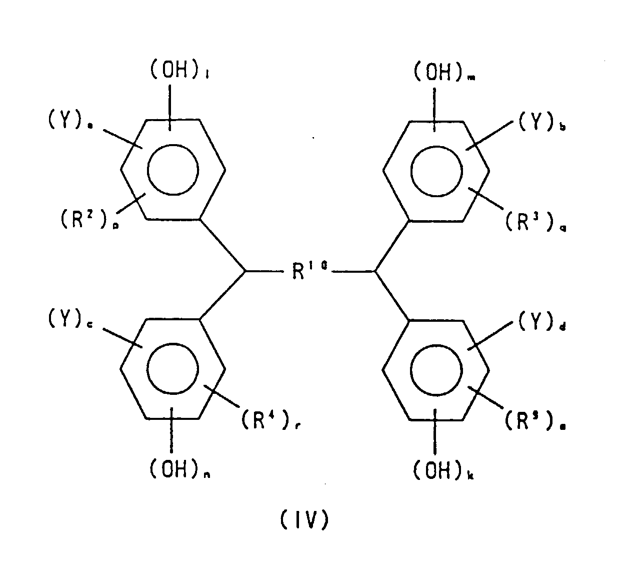 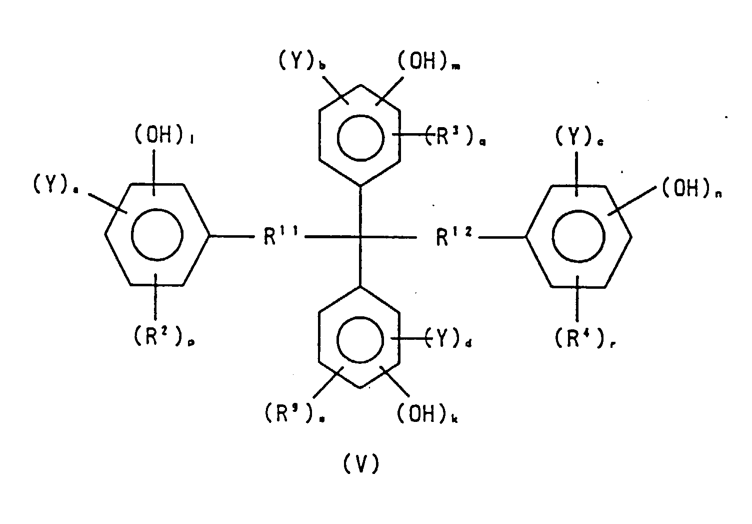 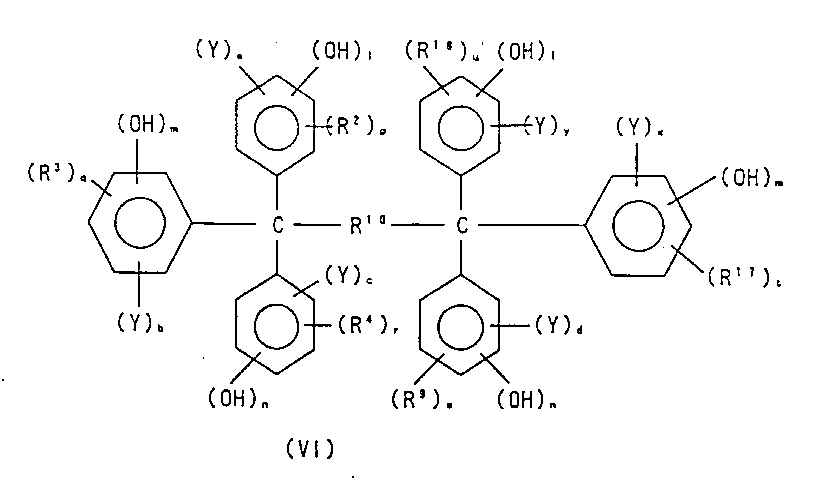 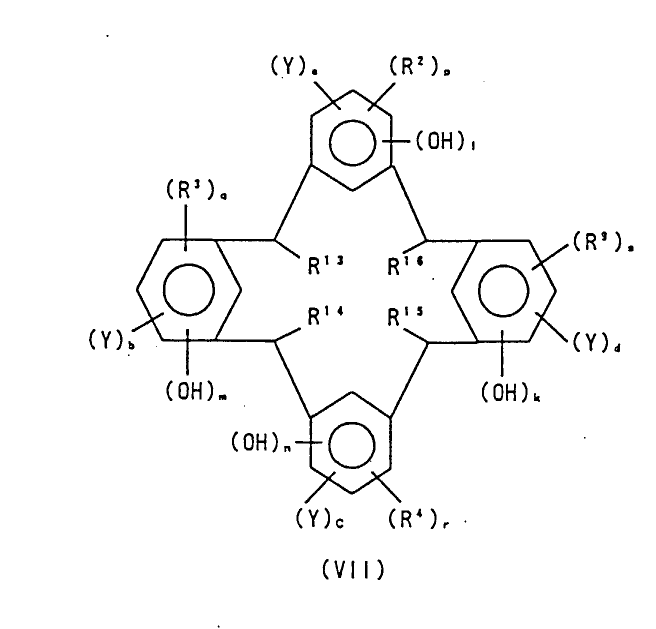 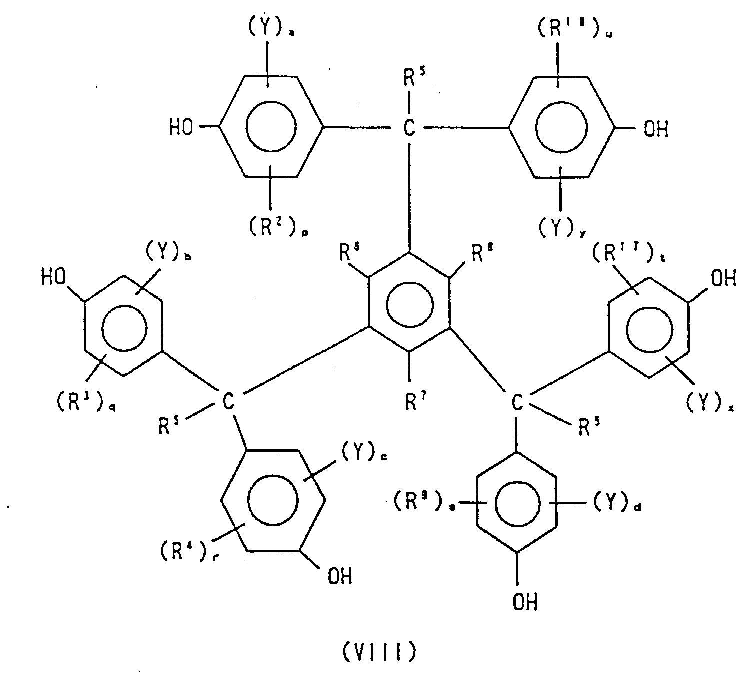 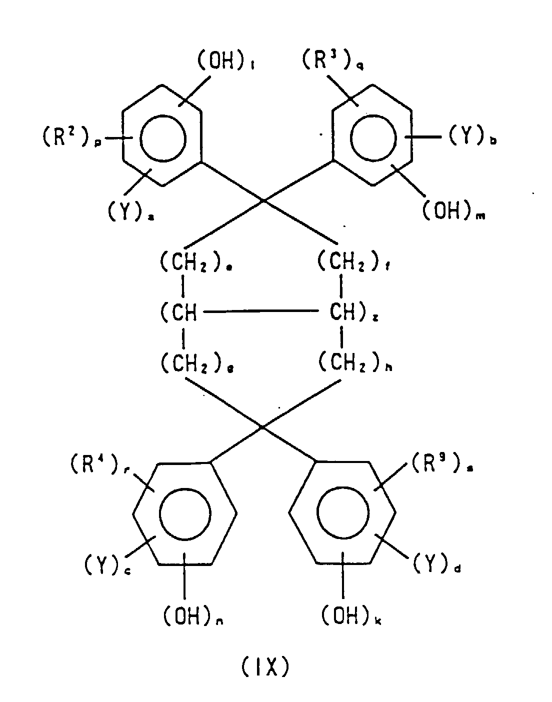 wherein R² to R⁴, R⁹, R¹⁷ and R¹⁸ each represents a hydrogen or halogen atom or an alkyl or alkoxy group; R⁵ and R¹³ to R¹⁶ each represents a hydrogen atom or an alkyl group; R⁶ to R⁸ each represents a hydrogen or halogen atom or an alkyl group; R¹⁰ to R¹² each represents a single bond, a substituted or unsubstituted alkylene, alkenylene, phenylene. naphthylene, carbonyl, ether or thioether group, or an amido bond, or a group formed from at least two of these groups; Y represents a group represented by the following general formula (I):
-CH₂OR¹ (I)
wherein R¹ represents a hydrogen atom, an alkyl or an acyl group; a, b, c, d, x and y each represents an integer ranging from 0 to 3, provided that the sum of them, a+b+c+d+x+y, is an integer ranging from 2 to 16; k, l, m and n each represents an integer ranging from 0 to 3, provided that all of them are not simultaneously 0; e, f, g, h, p, q, r, s, t and u each represents an integer ranging from 0 to 3; and z is 0 or 1.

2. The use of claim 1, wherein, in the general formula (I), the alkyl group denoted by R¹ represents an alkyl group having 1 to 4 carbon atoms and the acyl group denoted by R¹ represents a formyl, acetyl, butyryl, benzoyl, cinnamoyl or valeryl group.

3. The use of claim 1, wherein the phenol derivative is at least one member selected from the group consisting of those represented by the general formulas (II) to (IX) in which all of a, b, c, d, x and y are zero.

4. The use of claim 1, wherein the phenol derivative is at least one member selected from the group consisting of those represented by the general formulas (X) to (XVII): 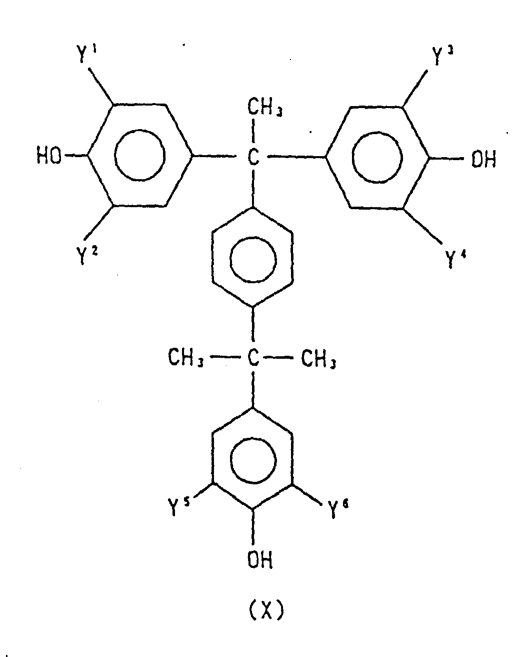 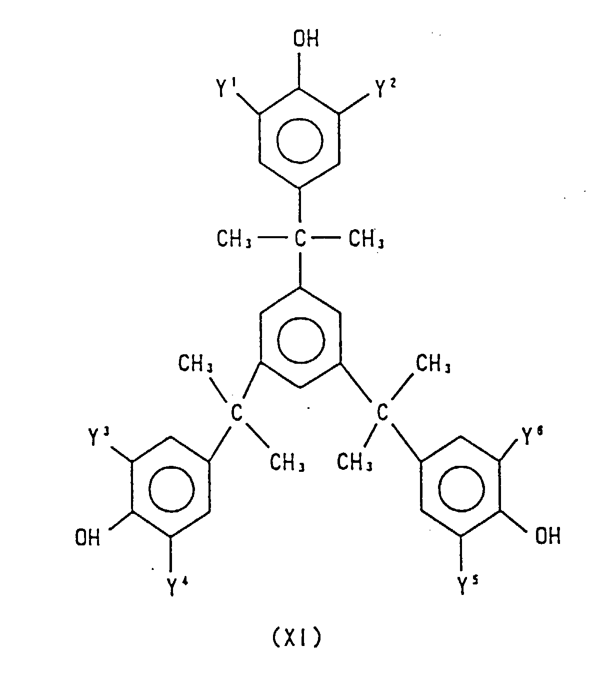 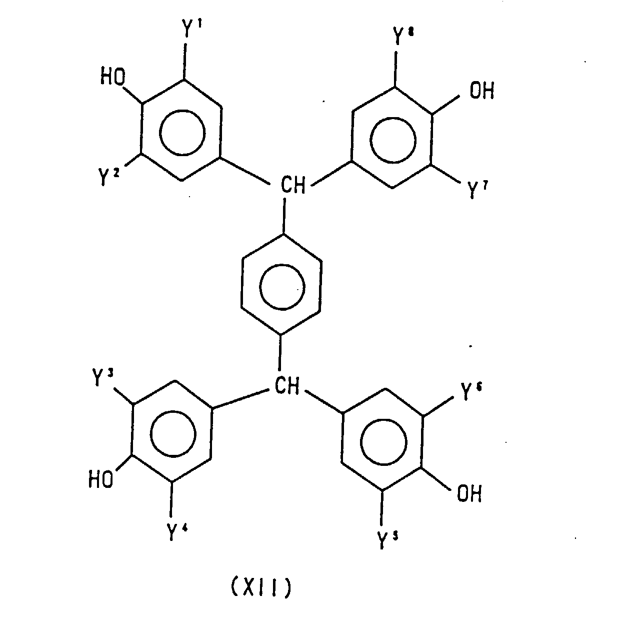 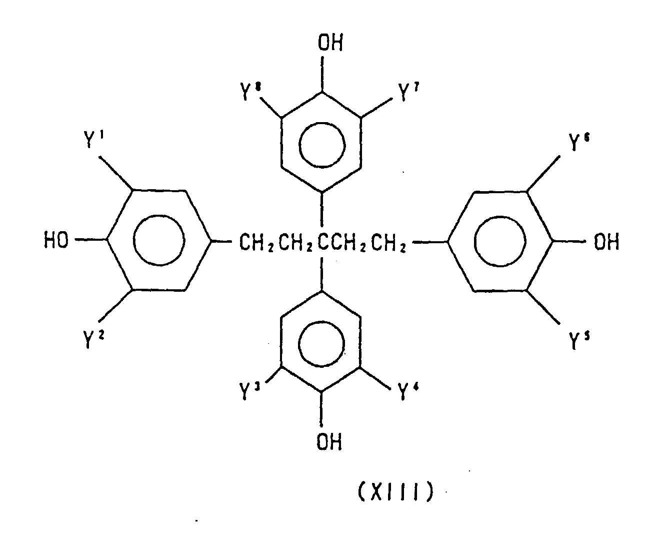 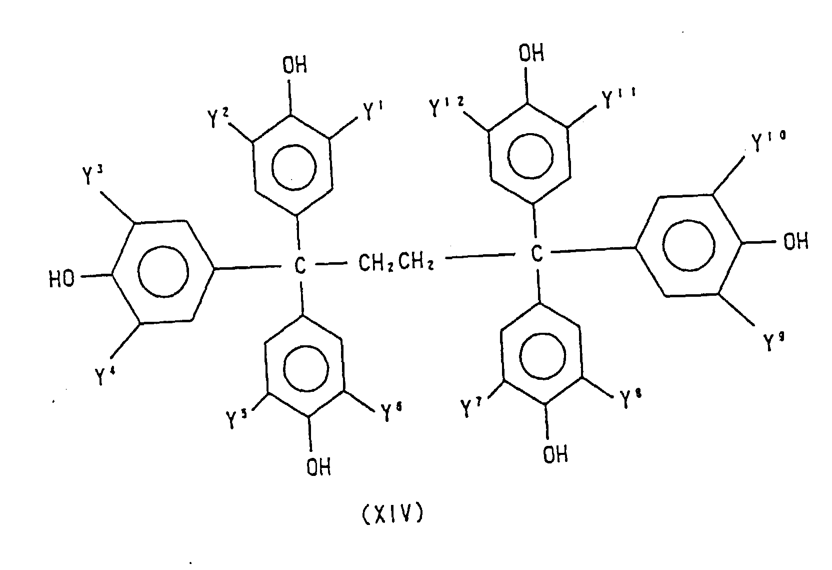 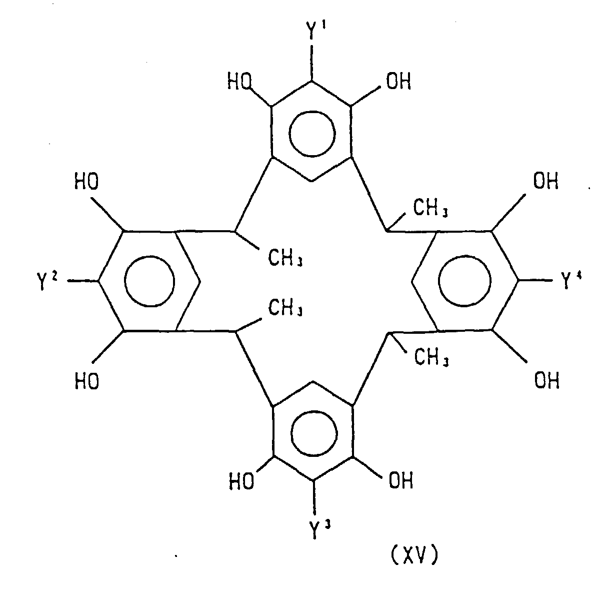 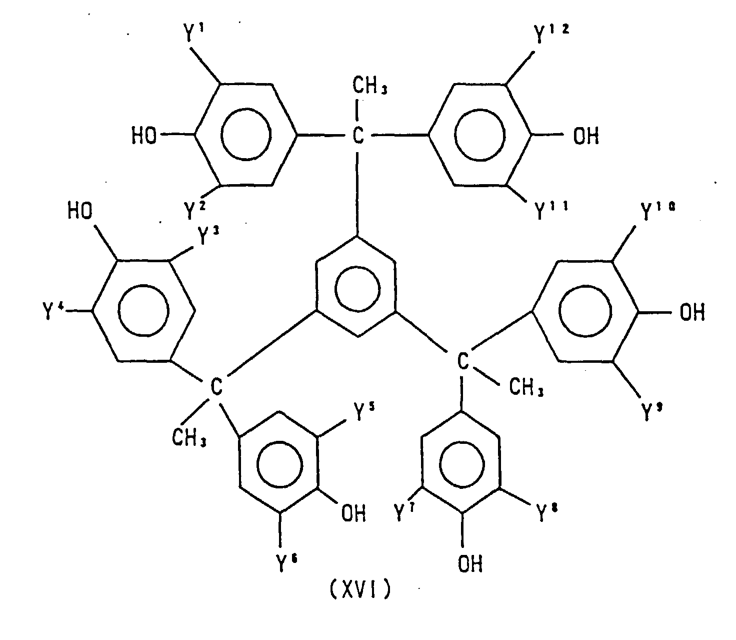 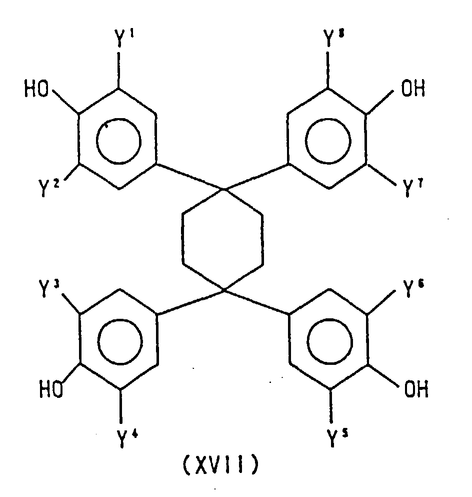 wherein Y¹ to Y¹² each represents a hydrogen atom or a group represented by Formula (I), provided that at least two of them in each compound represent the groups represented by Formula (I).

5. The use of claim 1, wherein the light-sensitive composition is substantially free of a compound having 1 to 3 benzene nuclei, a phenolic hydroxyl group and a group represented by the general formula (I).

6. The use of claim 1, wherein the phenol derivative is added to the light-sensitive composition in an amount ranging from 0.2 to 60% by weight on the basis of the total weight of the composition.

7. The use of claim 6, wherein the phenol derivative is added to the light-sensitive composition in an amount ranging from 0.5 to 20% by weight on the basis of the total weight of the composition.

8. The use of claim 1, comprising the steps of:
imagewise exposing to light the positive-working presensitized plate as defined in claim 1,
developing the light exposed presensitized plate, and then subjecting the developed plate to burning treatment.

## Patentansprüche

1. Verwendung einer positiv arbeitenden vorsensibilisierten Platte zur Herstellung einer lithographischen Druckplatte, besagte positiv arbeitende vorsensibilisierte Platte umfaßt ein Substrat mit einer darauf vorgesehenen lichtempfindlichen Schicht, wobei die lichtempfindliche Schicht aus einer positiv arbeitenden lichtempfindlichen Zusammensetzung geformt wird, besagte Zusammensetzung umfaßt ein Phenolderivat, ein wasserunlösliches und in alkalischem Wasser lösliches Harz und ein o-Chinondiazid oder ein Diazoniumsalz oder eine Mischung aus einer Verbindung, die fähig ist, bei Aussetzung zu Licht eine Säure zu formen, mit einer Verbindung, die mindestens eine C-O-C-Gruppe enthält, die durch Einwirkung der Säure zersetzt wird, besagtes Phenolderivat und besagtes wasserunlösliches und in alkalischem Wasser lösliches Harz sind verschieden voneinander, besagtes Phenolderivat ist mindestens eins ausgewählt aus der Gruppe bestehend aus Verbindungen, die durch die folgenden allgemeinen Formeln (II) bis (IX) dargestellt werden: 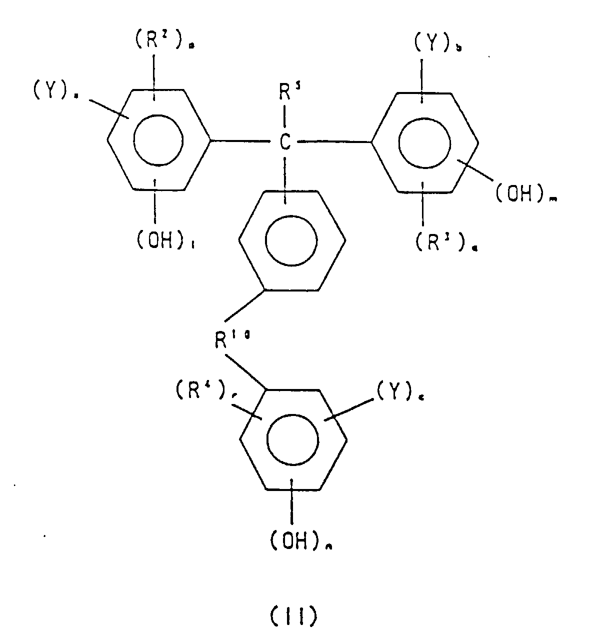 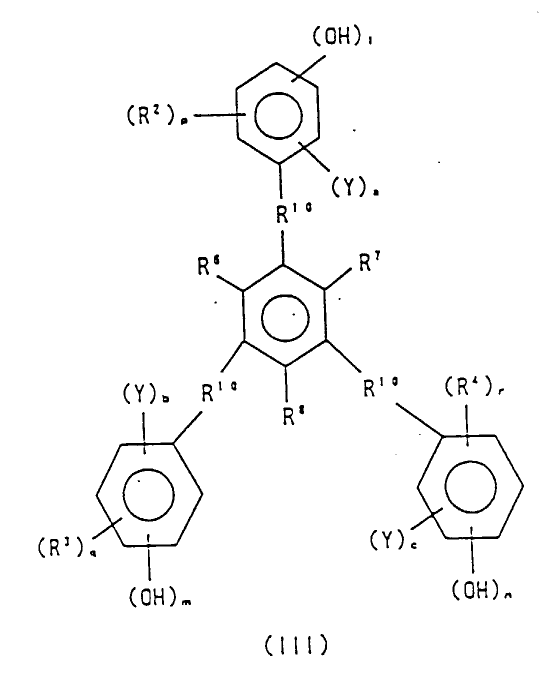 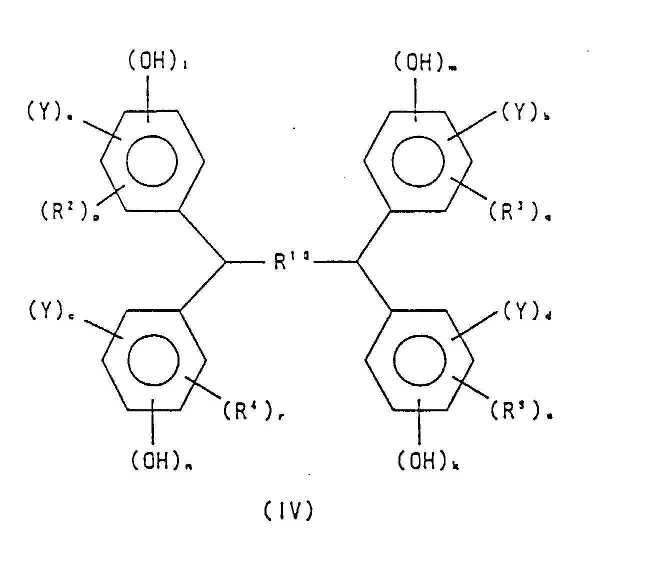 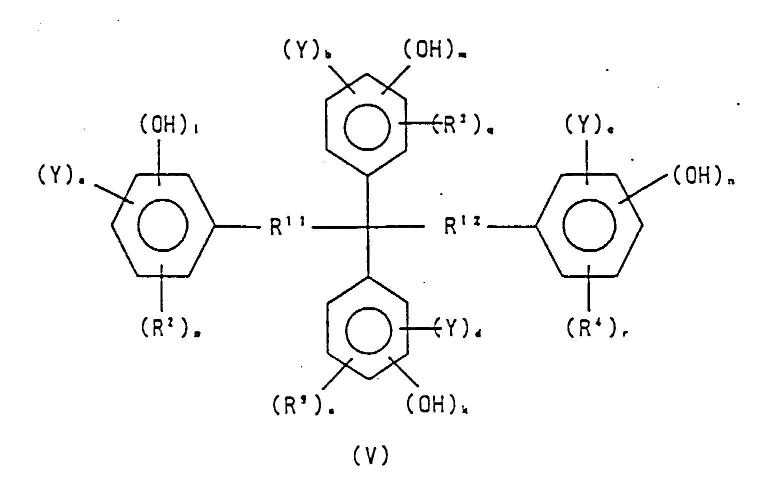 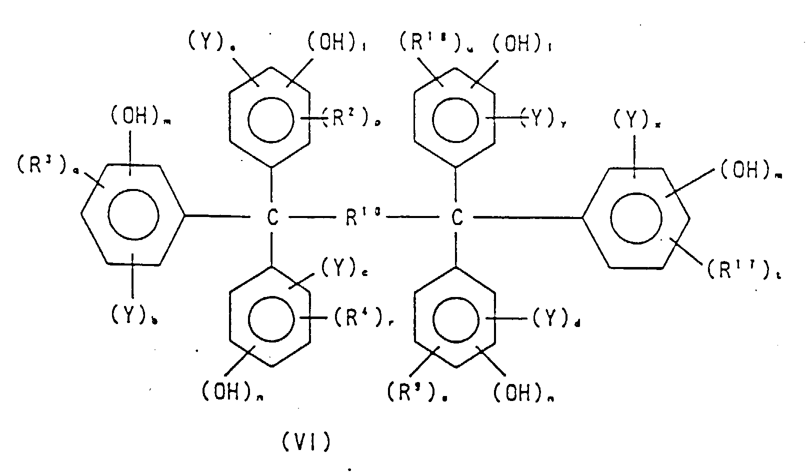 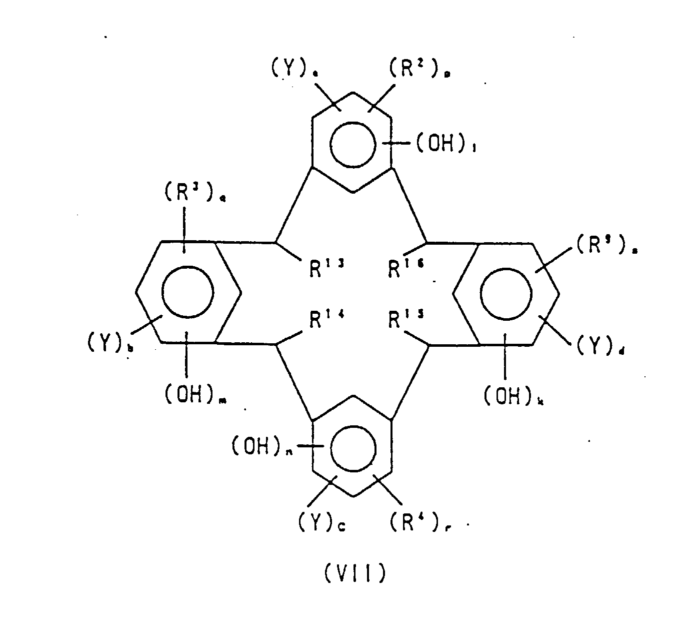 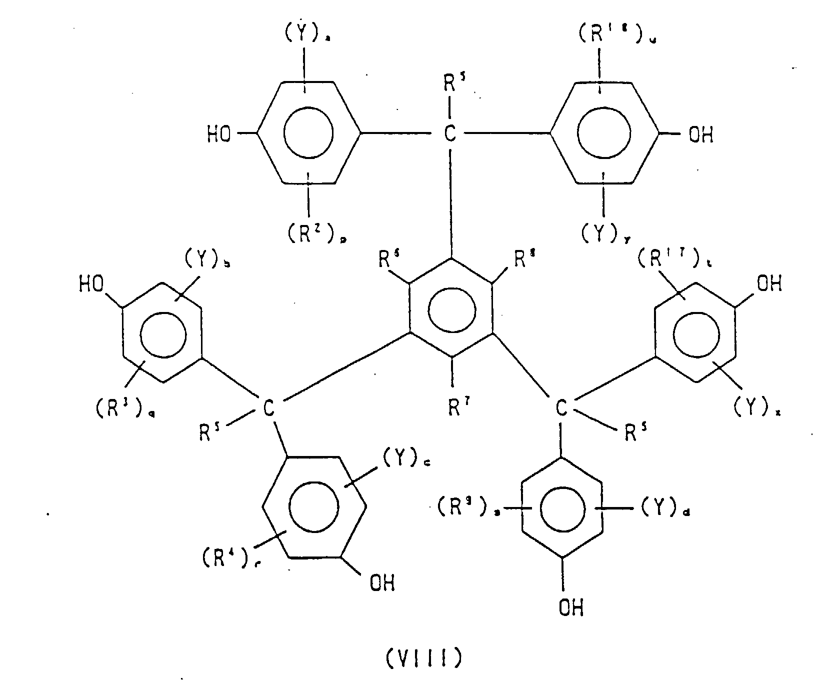 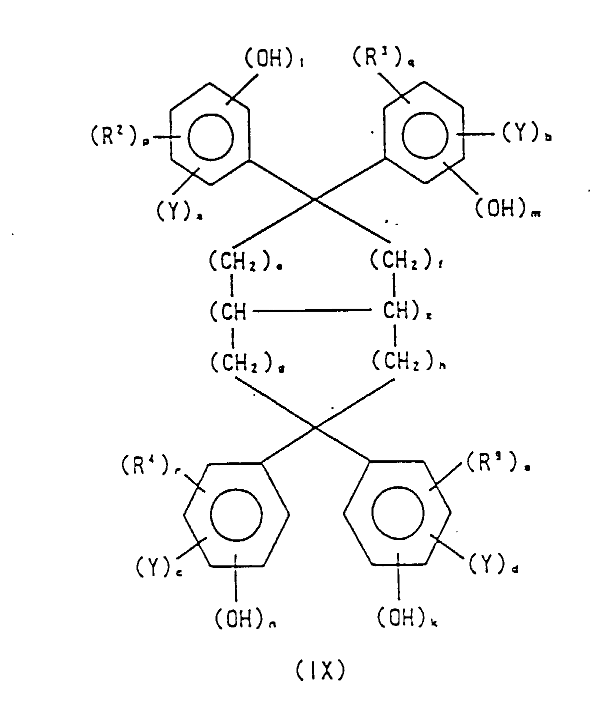 wobei R² bis R⁴, R⁹, R¹⁷ und R¹⁸ jeweils Wasserstoff oder ein Halogenatom oder eine Alkyl- oder Alkoxygruppe darstellen; R⁵ und R¹³ bis R¹⁶ jeweils ein Wasserstoffatom oder eine Alkylgruppe darstellen; R⁶ bis R⁸ jeweils ein Wasserstoffatom oder Halogenatom oder eine Alkylgruppe darstellen; R¹⁰ bis R¹² jeweils eine Einfachbindung, eine substituierte oder unsubstituierte Alkylen-, Alkenylen-, Phenylen-, Naphthylen-, Carbonyl-, Ether- oder Thioethergruppe, oder eine Amidobindung, oder eine Gruppe, geformt aus mindestens zweier dieser Gruppen darstellen; Y eine Gruppe der folgenden allgemeinen Formel (I) darstellt:
-CH₂OR¹ (I)
wobei R¹ ein Wasserstoffatom, eine Alkyl- oder Acylgruppe darstellt; a, b, c, d, x und y jeweils eine ganze Zahl im Bereich von 0 bis 3 darstellen, vorausgesetzt daß die Summe aus a + b + c + d + x + y eine ganze Zahl im Bereich von 2 bis 16 ist; k, l, m und n jeweils eine ganze Zahl im Bereich von 0 bis 3 darstellen, vorausgesetzt daß nicht alle von ihnen gleichzeitig 0 sind; e, f, g, h, p, q, r, s, t und u jeweils eine ganze Zahl im Bereich von 0 bis 3 darstellen; und z 0 oder 1 ist.

2. Verwendung nach Anspruch 1, dadurch gekennzeichnet, daß in der allgemeinen Formel (I) die Alkylgruppe, dargestellt durch R¹, eine Alkylgruppe mit 1 bis 4 Kohlenstoffatomen ist und die Acylgruppe, dargestellt durch R¹, eine Formyl-, Acetyl-, Butyryl-, Benzoyl-, Cinnamoyl- oder Valerylgruppe ist.

3. Verwendung nach Anspruch 1, dadurch gekennzeichnet, daß das Phenolderivat mindestens ein Mitglied, ausgewählt aus der Gruppe bestehend aus Verbindungen, dargestellt durch die allgemeinen Formel (II) bis (IX), in denen sowohl a, b, c, d, x und auch y 0 sind, ist.

4. Verwendung nach Anspruch 1, dadurch gekennzeichnet, daß das Phenolderivat mindestens ein Mitglied, ausgewählt aus der Gruppe bestehend aus den Verbindungen, die durch allgemeinen Formeln (X) bis (XVII) dargestellt werden: 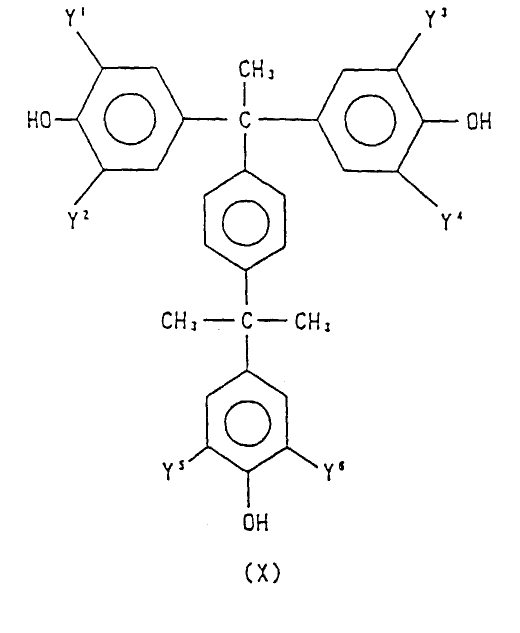 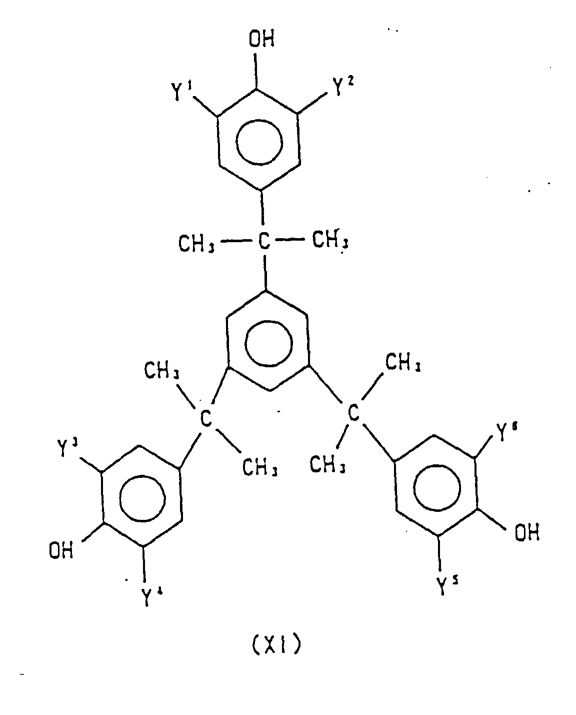 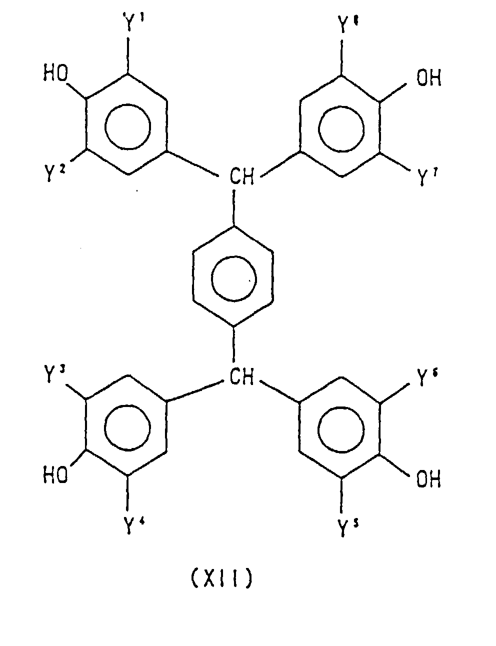 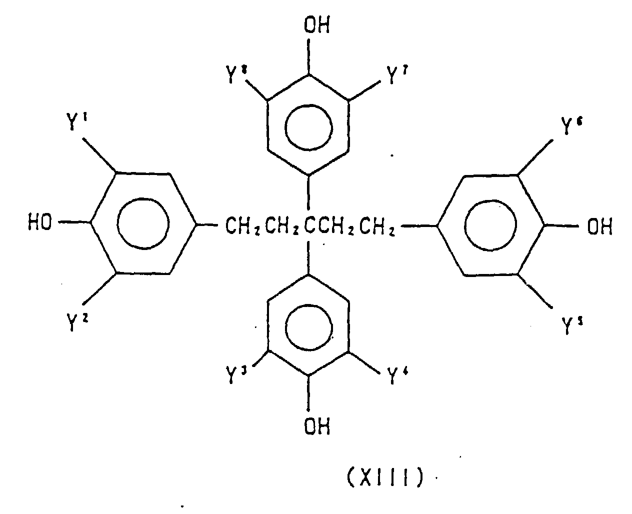 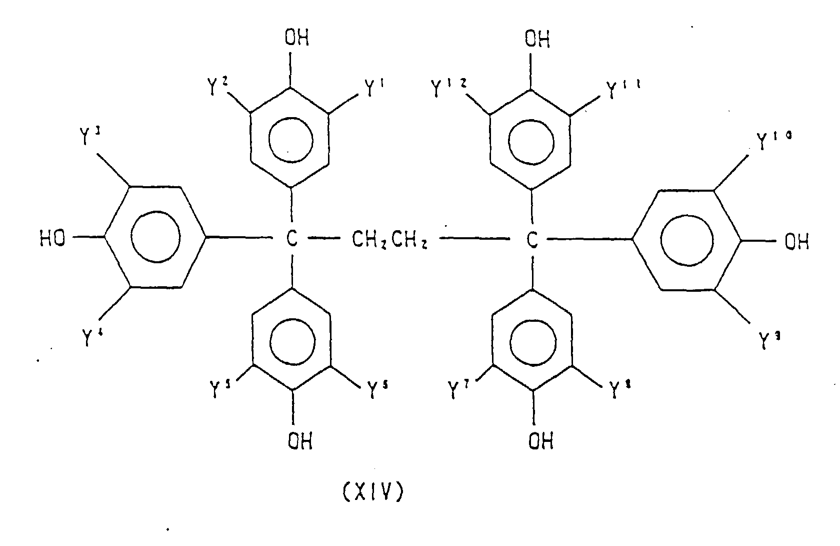 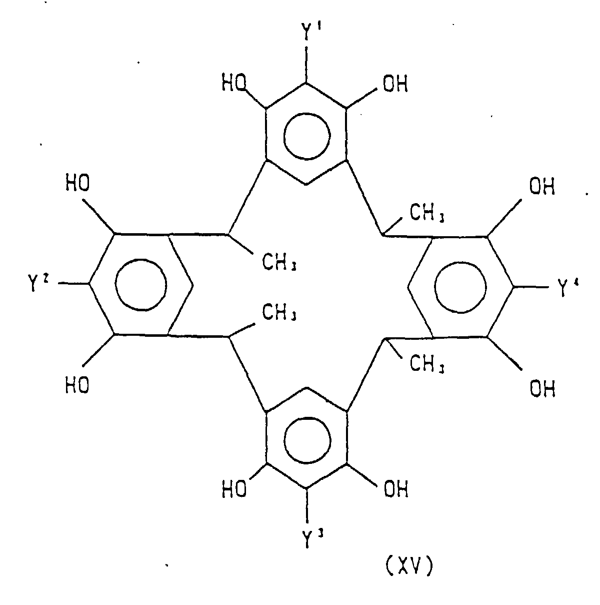 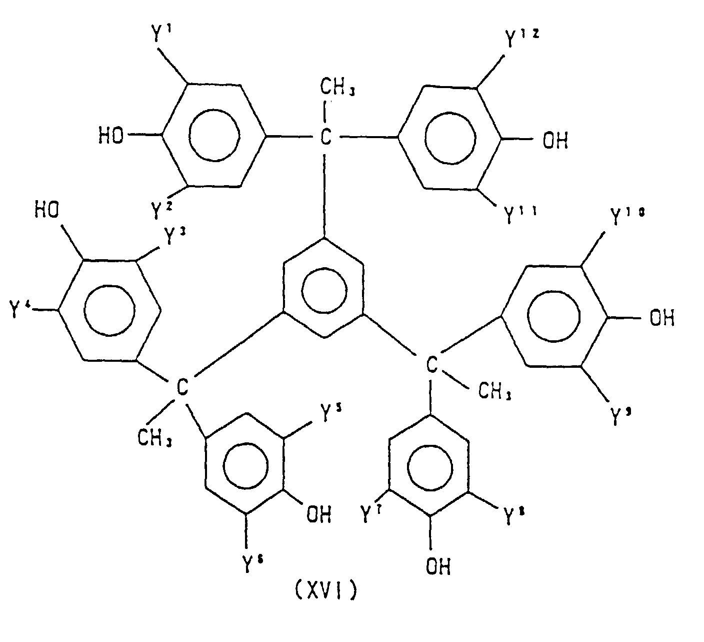 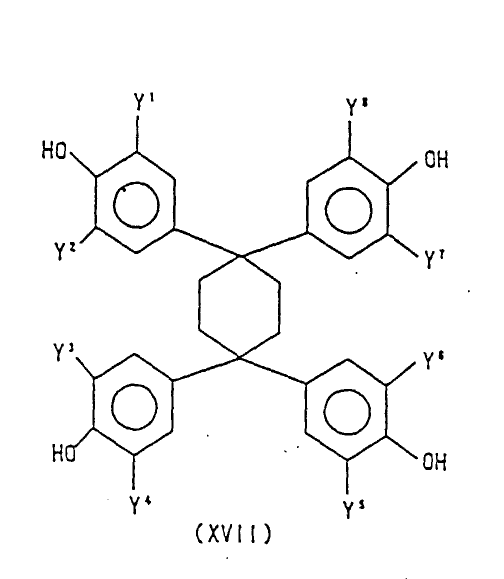 wobei Y¹ bis Y¹² jeweils ein Wasserstoffatom oder eine Gruppe, dargestellt durch Formel (I) darstellt, vorausgesetzt daß mindestens zwei von ihnen, in jeder Verbindung, Gruppen dargestellt durch Formel (I) sind, ist.

5. Verwendung nach Anspruch 1, dadurch gekennzeichnet, daß die lichtempfindliche Zusammensetzung im wesentlichen frei von Verbindung mit 1 bis 3 Benzolkernen, phenolischen Hydroxylgruppen und einer Gruppe, dargestellt durch die allgemeine Formel (I), ist.

6. Verwendung nach Anspruch 1, dadurch gekennzeichnet, daß das Phenolderivat in einer Menge von 0,2 bis 60 Gew.-%, bezogen auf das Gesamtgewicht der Zusammensetzung, zur lichtempfindlichen Zusammensetzung zugegeben wird.

7. Verwendung nach Anspruch 6, dadurch gekennzeichnet, daß das Phenolderivat in einer Menge von 0,5 bis 20 Gew.-%, bezogen auf das Gesamtgewicht der Zusammensetzung, zur lichtempfindlichen Zusammensetzung zugegeben wird.

8. Verwendung nach Anspruch 1, umfassend die Schritte:
Bildweises Belichten der in Anspruch 1 definierten positiv arbeitenden vorsensibilisierten Platte mit Licht, Entwickeln der belichteten vorsensibilisierten Platte und Unterwerfen der entwickelten Platte einer Brennbehandlung.

## Revendications

1. Utilisation d'une plaque présensibilisée travaillant positivement pour la production d'une plaque d'impression lithographique, ladite plaque présensibilisée travaillant positivement comprenant un substrat muni sur lui d'une couche sensible à la lumière, caractérisée en ce que la couche sensible à la lumière est formée d'une composition sensible à la lumière travaillant positivement comprenant un dérivé phénolique, une résine insoluble dans l'eau et soluble dans l'eau alcaline et un o-quinonediazide ou un sel de diazonium ou un mélange d'un composé capable de former un acide par exposition à la lumière avec un composé ayant au moins un groupe C-O-C capable d'être décomposé par l'action de l'acide, ledit dérivé phénolique et ladite résine insoluble dans l'eau et soluble dans l'eau alcaline étant différents l'un de l'autre, ledit dérivé phénolique étant au moins un membre choisi dans le groupe consistant en ceux représentés par les formules générales suivantes (Il) à (IX): 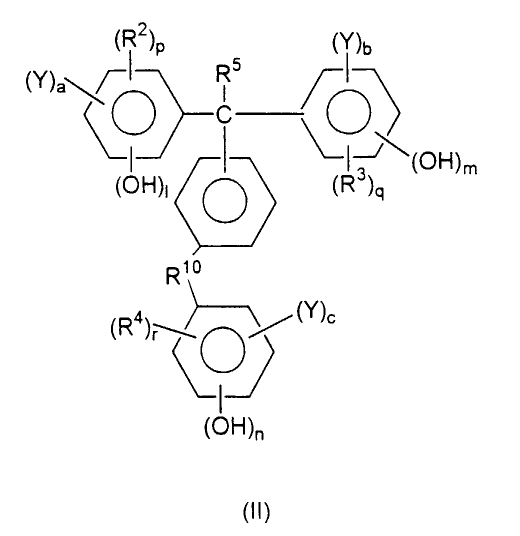 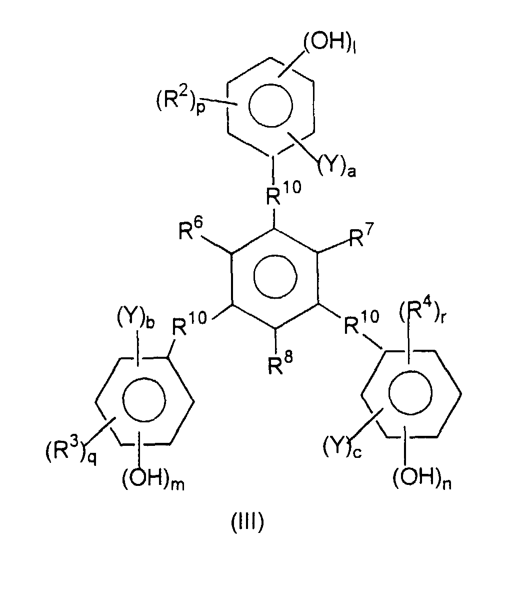 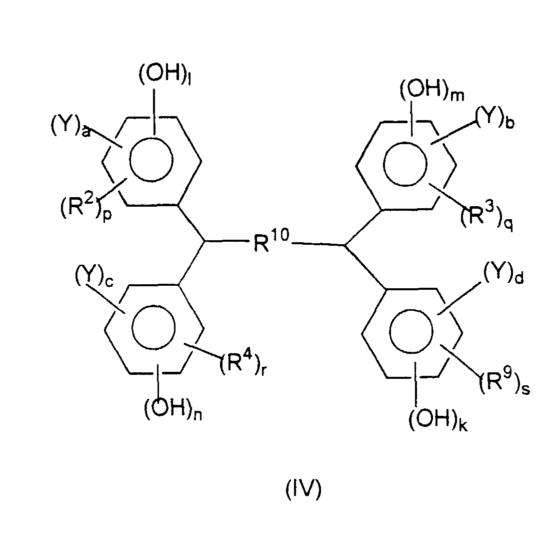 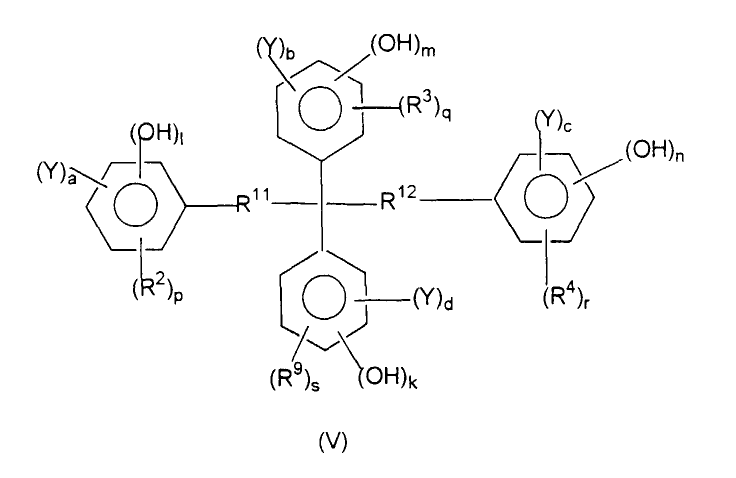 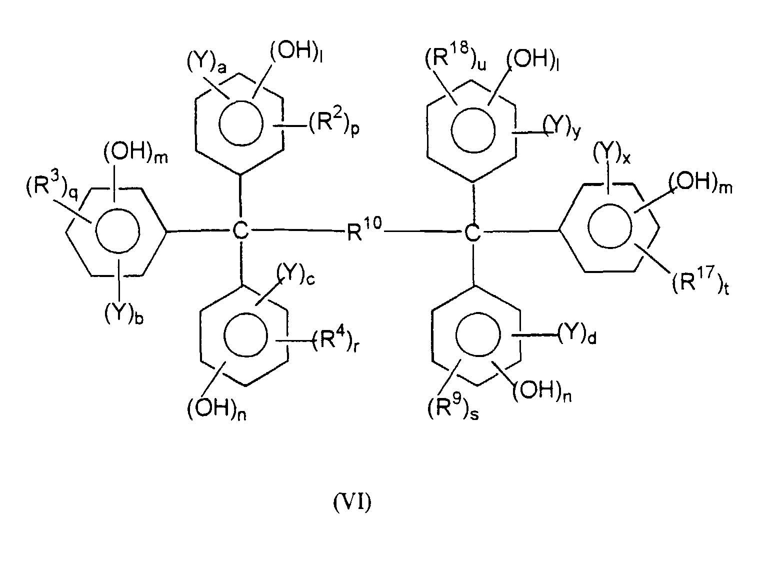 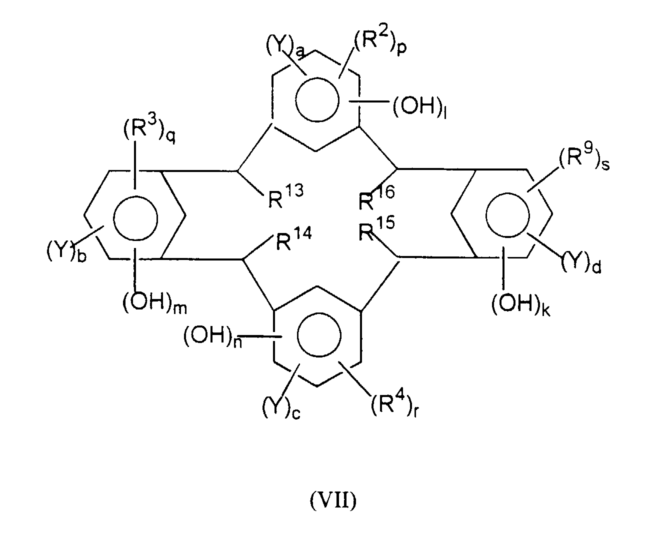 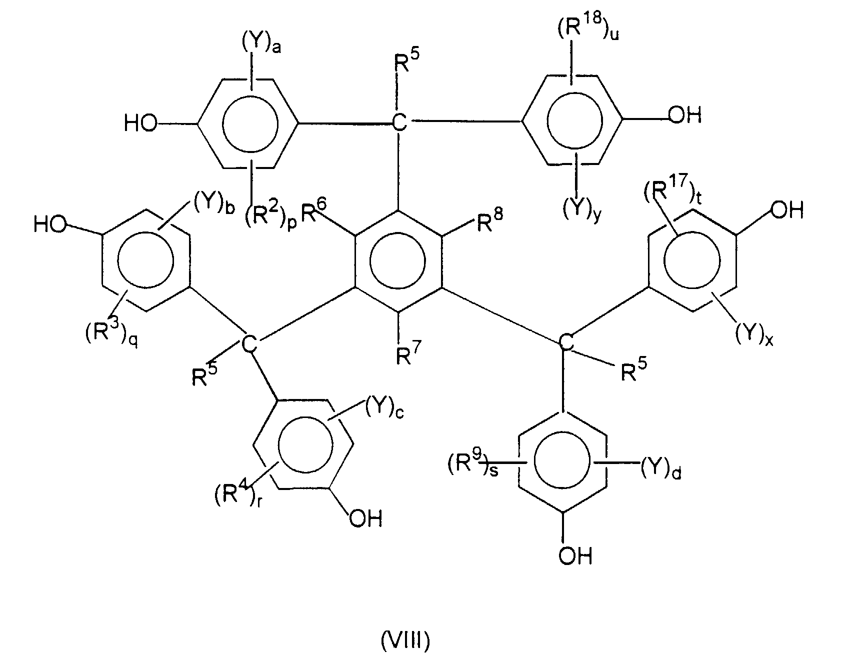 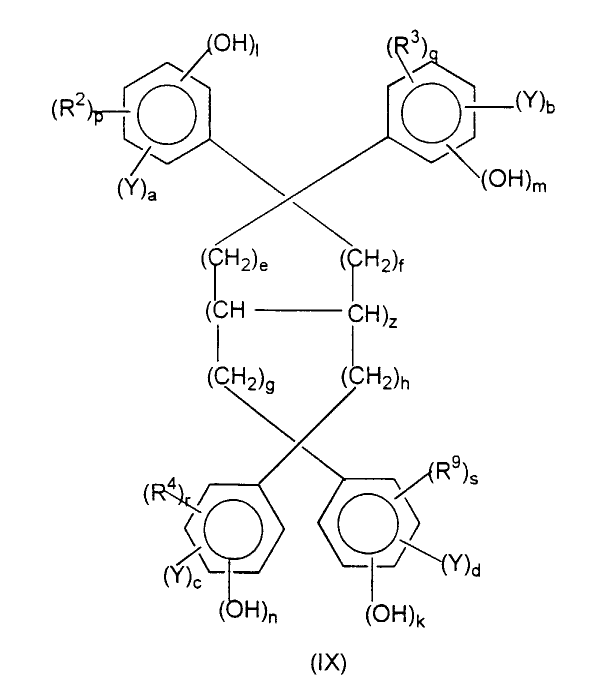 dans lesquelles R² à R⁴, R⁹, R¹⁷ et R¹⁸ représentent chacun un hydrogène ou un atome d'halogène ou un groupe alkyle ou alcoxy; R⁵ et R¹³ à R¹⁶ représentent chacun un atome d'hydrogène ou un groupe alkyle; R⁶ à R⁸ représentent chacun un hydrogène ou un atome d'halogène ou un groupe alkyle; R¹⁰ à R¹² représentent chacun une liaison simple, un groupe alkylène, alcénylène, phénylène, naphtylène, carbonyle, éther ou thioéther substitué ou non substitué, ou une liaison amido, ou un groupe formé par au moins deux de ces groupes; Y représente un groupe représenté par la formule générale suivante (I):
-CH₂OR¹ (I)
dans laquelle R¹ représente un atome d'hydrogène, un groupe alkyle ou acyle; a, b, c, d, x et y représentent chacun un entier compris entre 0 et 3, à condition que la somme d'eux a+b+c+d+x+y soit un entier compris entre 2 et 16; k, I, m et n représentent chacun un entier compris entre 0 et 3, à condition que tous ceux-ci ne soient pas simultanément 0; e, f, g, , h, p, q, r, s, t et u représentent chacun un entier compris entre 0 et 3; et z est égal à 0 ou 1.

2. Utilisation selon la revendication 1, caractérisée en ce que, dans la formule générale (I), le groupe alkyle noté par R¹ représente un groupe alkyle ayant de 1 à 4 atomes de carbone et le groupe acyle noté par R¹ représente un groupe formyle, acétyle, butyryle, benzoyle, cinnamoyle ou valéryle.

3. Utilisation selon la revendication 1, caractérisée en ce que le dérivé phénolique est au moins un membre choisi dans le groupe formé par ceux représentés par les formules générales (Il) à (IX) dans lesquelles tous les a, b, c, d, x et y sont égaux à 0.

4. Utilisation selon la revendication 1, caractérisée en ce que le dérivé phénolique est au moins un membre choisi dans le groupe formé par ceux représentés par les formules générales (X) à (XVII): 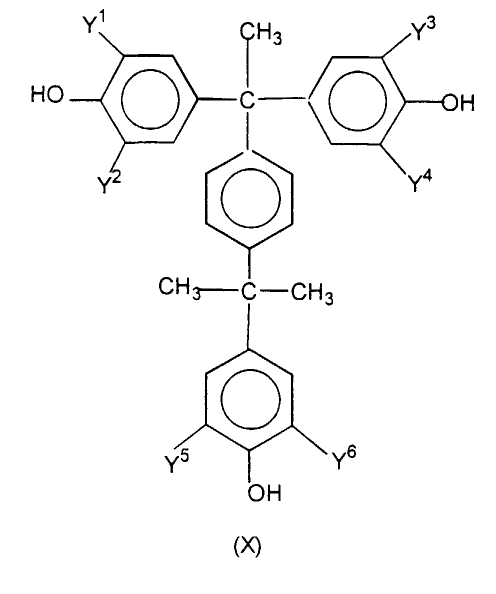 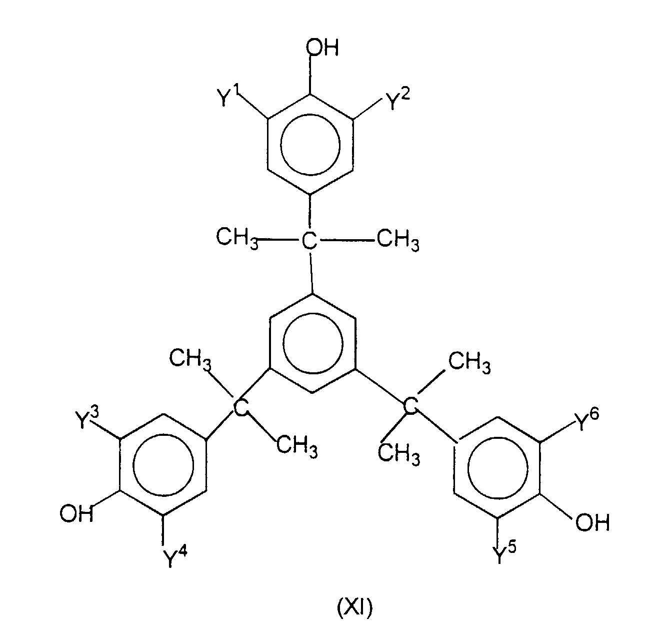 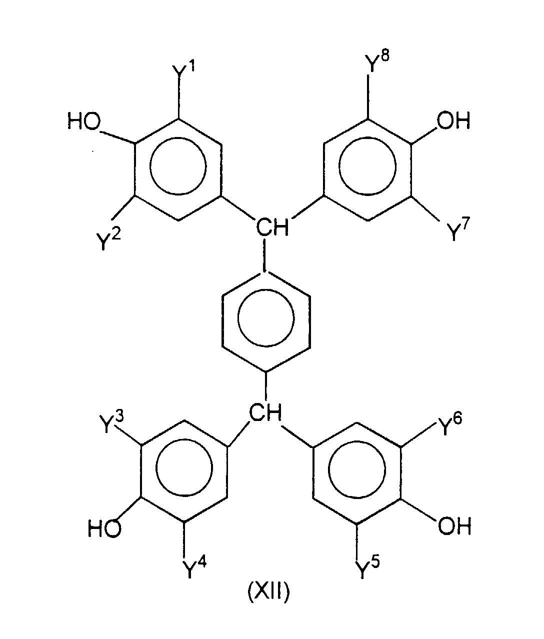 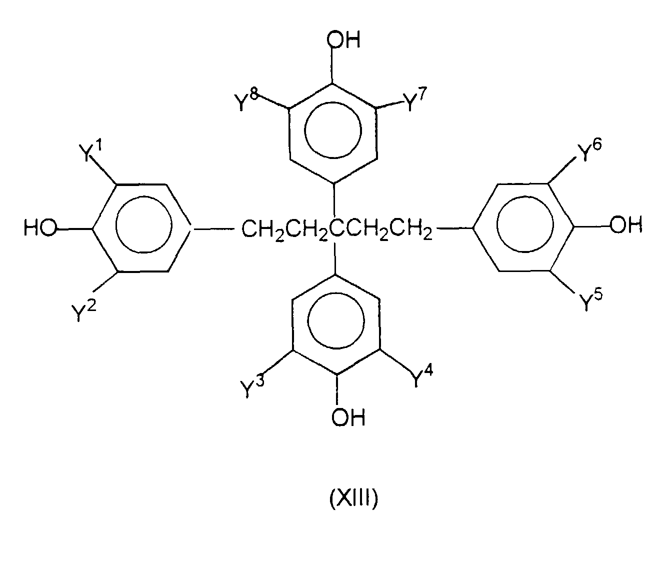 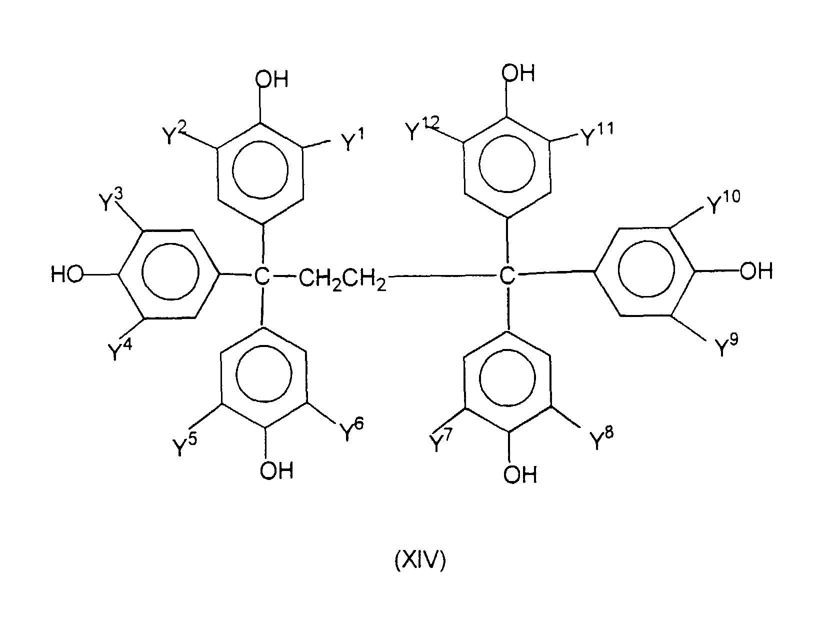 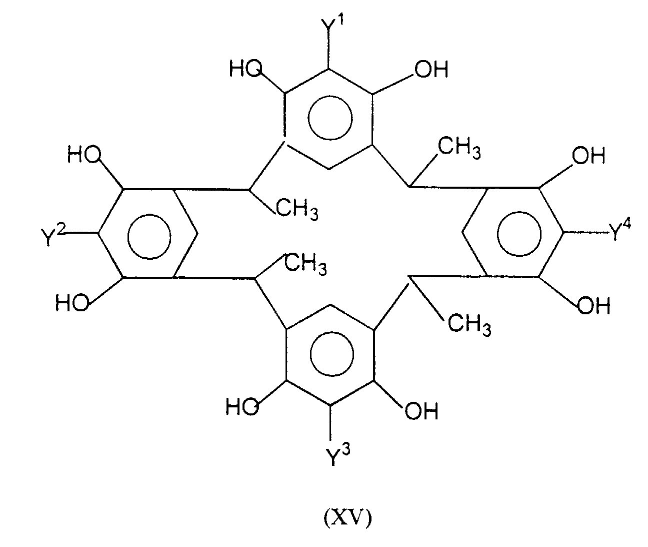 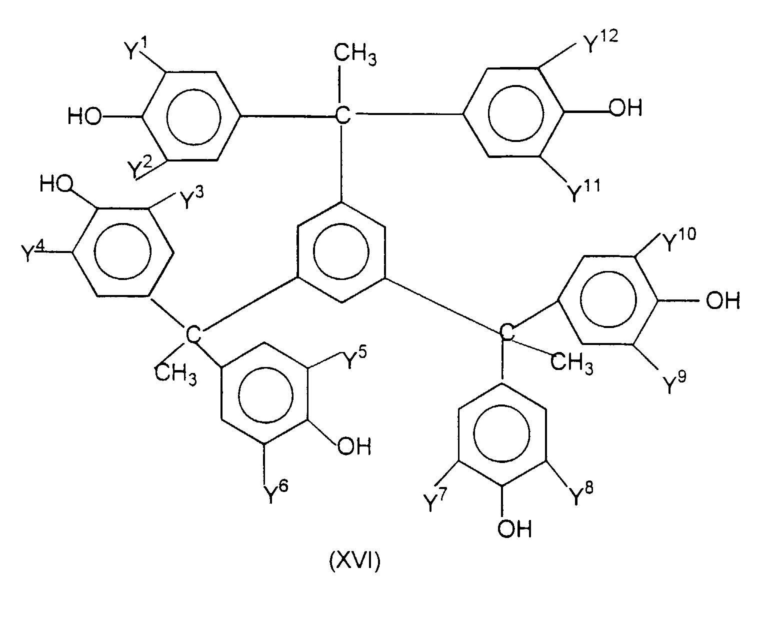 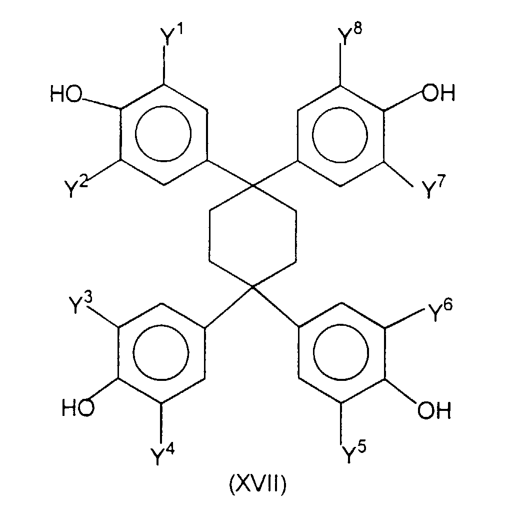 dans lesquelles Y¹ à Y¹² représentent chacun un atome d'hydrogène ou un groupe représenté par la Formule (I), à condition qu'au moins deux d'entre eux dans chaque composé représentent les groupes représentés par la Formule (I).

5. Utilisation selon la revendication 1, caractérisée en ce que la composition sensible à la lumière est essentiellement dépourvue d'un composé ayant de 1 à 3 noyaux benzéniques, un groupe hydroxyle phénolique et un groupe représenté par la formule générale (I).

6. Utilisation selon la revendication 1, caractérisée en ce qu'on ajoute le dérivé phénolique à la composition sensible à la lumière dans une quantité dans l'intervalle de 0,2 à 60 % en poids sur la base du poids total de la composition.

7. Utilisation selon la revendication 6, caractérisée en ce qu'on ajoute le dérivé phénolique à la composition sensible à la lumière dans une quantité dans l'intervalle de 0,5 à 20 % en poids sur la base du poids total de la composition.

8. Utilisation selon la revendication 1, comprenant les étapes de: exposer à la lumière avec formation d'image la plaque présensibilisée travaillant positivement telle que définie dans la revendication 1, développer la plaque présensibilisée exposée à la lumière, et ensuite soumettre la plaque développée à un traitement de chauffage.
